(19) Europäisches Patentamt
European Patent Office
Office européen des brevets

(11) EP 4 243 271 A1

(12) **EUROPEAN PATENT APPLICATION**
published in accordance with Art. 153(4) EPC

(43) Date of publication:
**13.09.2023 Bulletin 2023/37**

(21) Application number: **21889237.0**

(22) Date of filing: **04.11.2021**

(51) International Patent Classification (IPC):
***H02M 7/48*** *(2007.01)*

(52) Cooperative Patent Classification (CPC):
**H02M 7/48**

(86) International application number:
**PCT/JP2021/040626**

(87) International publication number:
**WO 2022/097685 (12.05.2022 Gazette 2022/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.11.2020 JP 2020186355**
**04.12.2020 JP 2020201669**

(71) Applicant: **Hitachi Astemo, Ltd.**
**Ibaraki 312-8503 (JP)**

(72) Inventors:
- **MOGI, Takuya**
  **Hitachinaka-shi, Ibaraki 312-8503 (JP)**
- **TSUKAGOSHI, Hideto**
  **Hitachinaka-shi, Ibaraki 312-8503 (JP)**

(74) Representative: **Eisenführ Speiser**
**Patentanwälte Rechtsanwälte PartGmbB**
**Postfach 31 02 60**
**80102 München (DE)**

# (54) TEMPERATURE ESTIMATION DEVICE AND CONTROL DEVICE

(57) Provided is a temperature estimation device configured to estimate operating temperatures of an upper arm and a lower arm in an inverter circuit, the inverter circuit including one or a plurality of switching legs, each switching leg comprising the upper arm and the lower arm, each of the upper arm and the lower being provided with a freewheeling diode, wherein the operating temperature is estimated on the basis of a forward voltage and a forward current of the freewheeling diode acquired from the inverter circuit in an extended time width, the extended time width in which a dead time between the upper arm and the lower arm is extended to be longer than a predetermined time width.

FIG. 1

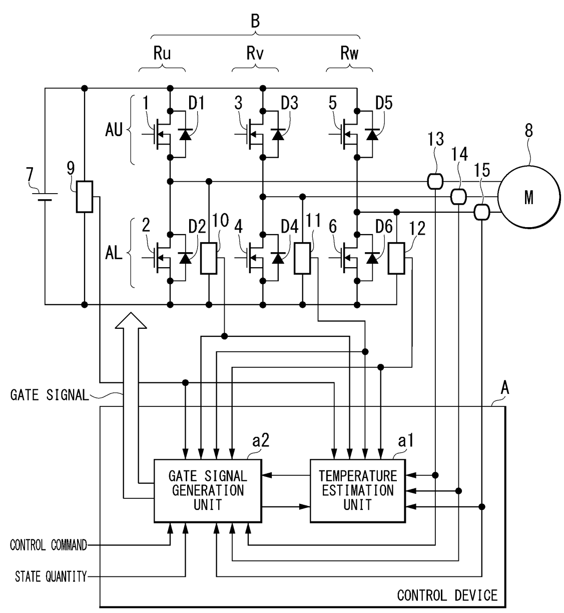


EP 4 243 271 A1

## Description

[Technical Field]

The present invention relates to a temperature estimation device and a control device.

Priority is claimed on Japanese Patent Application No. 2020-186355 filed in Japan on November 9, 2020, the contents of which are incorporated herein by reference. Priority is claimed on Japanese Patent Application No. 2020-201669 filed in Japan on December 4, 2020, the contents of which are incorporated herein by reference.

[Background Art]

Patent Literature 1 below discloses a power converter. This power converter is a power converter intended to estimate a junction temperature of a switching element that follows a steep temperature rise with high accuracy and using a semiconductor switching element, and the power converter includes a current detection unit detecting a current flowing through the semiconductor switching element, a voltage detection unit detecting a saturation voltage and a forward voltage of the semiconductor switching element, and a control unit estimating a junction temperature of the semiconductor switching element from the saturation voltage, the forward voltage, and the current (forward current).

[Citation List]

[Patent Literature]

[Patent Literature 1]
Japanese Unexamined Patent Application, First Publication No. 2019-216571

[Summary of Invention]

[Technical Problem]

Incidentally, in the above-described power converter, the junction temperature of the semiconductor switching element is estimated as an operating temperature of the semiconductor switching element on the basis of the saturation voltage, the forward voltage, and the forward current which are characteristic quantities of the semiconductor switching element. However, in the above-described power converter, it is necessary to detect the characteristic quantities of the semiconductor switching element in a relatively short period of time, and this requires a high-speed operation, thereby reducing robustness with respect to noise.

The present invention has been made in view of the above circumstances, and an objective of the present invention is to estimate an operating temperature of a semiconductor switching element without requiring a high-speed operation.

[Solution to Problem]

(1) One aspect of the present invention provides a temperature estimation device configured to estimate operating temperatures of an upper arm and a lower arm in an inverter circuit, the inverter circuit including one or a plurality of switching legs, each switching leg including semiconductor switching elements of the upper arm and the lower arm, each of the upper arm and the lower being provided with a freewheeling diode, wherein the temperature estimation device configured to estimate the operating temperature on the basis of a forward voltage and a forward current of the freewheeling diode acquired from the inverter circuit in an extended time width, the extended time width in which a dead time between the upper arm and the lower arm is extended to be longer than a predetermined time width.

(2) In the temperature estimation device according to the above-described (1), of one and the other gate signals respectively controlling the upper arm and the lower arm, the extended time width may be set by causing an ON time of the other gate signal to be smaller than an ON time of one gate signal.

(3) In the temperature estimation device according to the above-described (1), of one and the other gate signals respectively controlling the upper arm and the lower arm, the extended time width may be set by removing an ON pulse of the other gate signal.

(4) In the temperature estimation device according to any one of the above-described (1) to (3), the operating temperature of the semiconductor switching element may be estimated on the basis of the forward voltage and the forward current of the freewheeling diode acquired from the inverter circuit when the freewheeling diode operates in a linear region.

(5) In the temperature estimation device according to any one of the above-described (1) to (4), the inverter circuit may be a three-phase inverter circuit having three switching legs provided therein, and the operating temperature may be estimated on the basis of the forward voltage and the forward current obtained from the three-phase inverter circuit.

(6) In the temperature estimation device according to any one of the above-described (1) to (5), when the inverter circuit includes a plurality of semiconductor switching elements, the operating temperature of some of the semiconductor switching elements may be estimated on the basis of heat dissipation performance of the plurality of the semiconductor switching elements.

(7) A temperature estimation device includes the temperature estimation device according to any one of the above-described (1) to (6), and a gate signal generation unit configured to generate a gate signal, the gate signal controlling the upper arm and the lower arm on the basis of the operating temperature estimated by the temperature estimation device.

[Advantageous Effects of Invention]

According to the present invention, since operating temperatures of the upper arm and the lower arm are estimated on the basis of the forward voltage and the forward current acquired in the extended time width, the operating temperatures can be estimated without requiring a high-speed operation.

[Brief Description of Drawings]

FIG. 1 is a block diagram showing functional configurations of a temperature estimation device and a control device according to a first embodiment.

FIG. 2 is a flowchart showing the entire operation of the temperature estimation device and the control device according to the first embodiment.

FIG. 3 is a timing chart showing operations of the temperature estimation device and the control device according to the first embodiment.

FIG. 4 is a flowchart showing detailed operations of the temperature estimation device and the control device according to the first embodiment.

FIG. 5 is a block diagram showing functional configurations of a temperature estimation device and a control device according to a second embodiment.

FIG. 6 is a graph showing a relationship between a forward current and a forward voltage of a body diode according to the second embodiment.

FIG. 7 is a flowchart showing the entire operation of the temperature estimation device and the control device according to the second embodiment.

FIG. 8 is a flowchart showing detailed operations of the temperature estimation device and the control device according to the second embodiment.

FIG. 9 is a timing chart showing operations of the temperature estimation device and the control device according to the second embodiment.

FIG. 10 is a schematic diagram showing a cooling structure of a three-phase inverter circuit according to the second embodiment.

[Description of Embodiments]

(First embodiment)

A control device A according to a first embodiment is a device intended for controlling a three-phase inverter circuit B as illustrated in FIG. 1, and includes a temperature estimation unit a1 and a gate signal generation unit a2 as functional components.

The three-phase inverter circuit B is formed of MOS transistors 1 to 6, converts DC power supplied from a DC power supply 7 into three-phase AC power, and supplies the three-phase AC power to a motor 8. The three-phase inverter circuit B includes switching legs Ru, Rv, and Rw corresponding to each of the phases, and collaterally includes voltage sensors 9 to 12 and current sensors 13 to 15.

Of these switching legs Ru, Rv, and Rw, the switching leg Ru is a U-phase switching leg corresponding to a U-phase. The switching leg Rv is a V-phase switching leg corresponding to a V-phase. The switching leg Rw is a W-phase switching leg corresponding to a W-phase.

These switching legs Ru, Rv, and Rw respectively include the MOS transistors 1, 3, and 5 forming upper arms and the MOS transistors 2, 4, and 6 forming lower arms. These MOS transistors 1 to 6 correspond to semiconductor switching elements of the present invention.

That is, the U-phase switching leg Ru includes the MOS transistor 1 of the upper arm and the MOS transistor 2 of the lower arm. The V-phase switching leg Rv includes the MOS transistor 3 of the upper arm and the MOS transistor 4 of the lower arm. The W-phase switching leg Rw includes the MOS transistor 5 of the upper arm and the MOS transistor 6 of the lower arm.

Further explaining these U-phase switching leg Ru, V-phase switching leg Rv, and W-phase switching leg Rw, in the U-phase switching leg Ru, the MOS transistor 1 of the upper arm and the MOS transistor 2 of the lower arm are connected in series to the DC power supply 7.

That is, the MOS transistor 1 of the upper arm has a drain terminal connected to a positive electrode of the DC power supply 7, a source terminal connected to a drain terminal of the MOS transistor 2 of the lower arm, and a gate terminal connected to the gate signal generation unit a2. The MOS transistor 1 of the upper arm is controlled to be in an ON state (ON state)/an OFF state (OFF state) according to a first gate signal input from the gate signal generation unit a2.

The MOS transistor 2 of the lower arm has the drain terminal connected to the above-described source terminal of the MOS transistor 1 of the upper arm, a source terminal connected to a negative electrode of the DC power supply 7, and a gate terminal connected to the gate signal generation unit a2. The MOS transistor 2 of the lower arm is controlled to be in an ON state (ON state)/an OFF state (OFF state) according to a second gate signal input from the gate signal generation unit a2.

Similarly to the U-phase switching leg Ru described above, the V-phase switching leg Rv includes the MOS transistor 3 of the upper arm and the MOS transistor 4 of the lower arm connected in series to the DC power supply 7.

That is, the MOS transistor 3 of the upper arm has a drain terminal connected to the positive electrode of the DC power supply 7, a source terminal connected to a drain terminal of the MOS transistor 4 of the lower arm, and a gate terminal connected to the gate signal generation unit a2. The MOS transistor 3 of the upper arm is controlled to be in an ON state (ON state)/an OFF state (OFF state) according to a third gate signal input from the gate signal generation unit a2.

The MOS transistor 4 of the lower arm has the drain terminal connected to the above-described source terminal of the MOS transistor 3 of the upper arm, a source terminal connected to the negative electrode of the DC power supply 7, and a gate terminal connected to the gate signal generation unit a2. The MOS transistor 4 of the lower arm is controlled to be in an ON state (ON state)/an OFF state (OFF state) according to a fourth gate signal input from the gate signal generation unit a2.

Similarly to the U-phase switching leg Ru and the V-phase switching leg Rv described above, the W-phase switching leg Rw includes the MOS transistor 5 of the upper arm and the MOS transistor 6 of the lower arm connected in series to the DC power supply 7.

That is, the MOS transistor 5 of the upper arm has a drain terminal connected to the positive electrode of the DC power supply 7, a source terminal connected to a drain terminal of the MOS transistor 6 of the lower arm, and a gate terminal connected to the gate signal generation unit a2. The MOS transistor 5 of the upper arm is controlled to be in an ON state (ON state)/an OFF state (OFF state) according to a fifth gate signal input from the gate signal generation unit a2.

The MOS transistor 6 of the lower arm has the drain terminal connected to the above-described source terminal of the MOS transistor 5 of the upper arm, a source terminal connected to the negative electrode of the DC power supply 7, and a gate terminal connected to the gate signal generation unit a2. The MOS transistor 6 of the lower arm is controlled to be in an ON state (ON state)/an OFF state (OFF state) according to a sixth gate signal input from the gate signal generation unit a2.

Also, in the U-phase switching leg Ru, the source terminal of the MOS transistor 1 of the upper arm and the drain terminal of the MOS transistor 2 of the lower arm connected to each other serve as an output end of the U-phase switching leg Ru. This output end is a U-phase output end of the three-phase inverter circuit B and is connected to a U-phase input end of the motor 8.

Also, in the V-phase switching leg Rv, the source terminal of the MOS transistor 3 of the upper arm and the drain terminal of the MOS transistor 4 of the lower arm connected to each other serve as an output end of the V-phase switching leg Rv. This output end is a V-phase output end of the three-phase inverter circuit B and is connected to a V-phase input end of the motor 8.

Further, in the W-phase switching leg Rw, the source terminal of the MOS transistor 5 of the upper arm and the drain terminal of the MOS transistor 6 of the lower arm connected to each other serve as an output end of the W-phase switching leg Rw. This output end is a W-phase output end of the three-phase inverter circuit B and is connected to a W-phase input end of the motor 8.

Body diodes D1 to D6 are collaterally provided to such MOS transistors 1 to 6 forming the three-phase inverter circuit B. The body diodes D1 to D6 function as freewheeling diodes that return a regenerated current based on a counter-electromotive force of the motor 8 to the DC power supply 7.

That is, the MOS transistor 1 of the upper arm of the U-phase switching leg Ru has the first body diode D1. As illustrated in the figure, the body diode D1 has a cathode terminal connected to the drain terminal of the MOS transistor 1 of the upper arm, and an anode terminal connected to the source terminal of the MOS transistor 1 of the upper arm.

Also, the MOS transistor 2 of the lower arm of the U-phase switching leg Ru has the body diode D2. As illustrated in the figure, the body diode D2 has a cathode terminal connected to the drain terminal of the MOS transistor 2 of the lower arm, and an anode terminal connected to the source terminal of the MOS transistor 2 of the lower arm.

The MOS transistor 3 of the upper arm of the V-phase switching leg Rv has the body diode D3. As illustrated in the figure, the body diode D3 has a cathode terminal connected to the drain terminal of the MOS transistor 3 of the upper arm, and an anode terminal connected to the source terminal of the MOS transistor 3 of the upper arm.

Also, the MOS transistor 4 of the lower arm of the V-phase switching leg Rv has the fourth body diode D4. As illustrated in the figure, the body diode D4 has a cathode terminal connected to the drain terminal of the MOS transistor 4 of the lower arm, and an anode terminal connected to the source terminal of the MOS transistor 4 of the lower arm.

The MOS transistor 5 of the upper arm of the W-phase switching leg Rw has the body diode D5. As illustrated in the figure, the body diode D5 has a cathode terminal connected to the drain terminal of the MOS transistor 5 of the upper arm, and an anode terminal connected to the source terminal of the MOS transistor 5 of the upper arm.

Also, the MOS transistor 6 of the lower arm of the W-phase switching leg Rw has the body diode D6. As illustrated in the figure, the body diode D6 has a cathode terminal connected to the drain terminal of the MOS transistor 6 of the lower arm, and an anode terminal connected to the source terminal of the MOS transistor 6 of the lower arm.

Such a three-phase inverter circuit B corresponds to a switching circuit of the present invention, and the MOS transistors 1 to 6 correspond to semiconductor switching elements of the present invention. That is, the three-phase inverter circuit B is an inverter circuit in which a plurality of switching legs each including a semiconductor switching element of the upper arm and a semiconductor switching element of the lower arm each having a freewheeling diode are provided.

Also, ON/OFF states of the MOS transistors 1 to 6 in the three-phase inverter circuit B are each set on the basis of a gate signal input from the control device A. The gate signal is a control pulse signal generated by the control device A for each of the MOS transistors 1 to 6. Also, the control pulse signal is, for example, a pulse width modulation (PWM) signal.

Of the voltage sensors 9 to 12 provided collaterally to such a three-phase inverter circuit B, the voltage sensor 9 is a sensor for detecting an input voltage of the three-phase inverter circuit B, that is, an output voltage (power supply voltage $V_D$) of the DC power supply 7, and outputs a detection signal (power supply voltage signal) indicating the power supply voltage $V_D$ to the temperature estimation unit a1 and the gate signal generation unit a2 of the control device A.

The voltage sensor 10 is a sensor for detecting an output voltage (U-phase voltage) of the U-phase switching leg Ru, and outputs a detection signal (U-phase voltage signal) indicating the U-phase voltage to the temperature estimation unit a1 and the gate signal generation unit a2 of the control device A. The voltage sensor 11 is a sensor for detecting an output voltage (V-phase voltage) of the V-phase switching leg Rv, and outputs a detection signal (V-phase voltage signal) indicating the V-phase voltage to the temperature estimation unit a1 and the gate signal generation unit a2 of the control device A. The voltage sensor 12 is a sensor for detecting an output voltage (W-phase voltage) of the W-phase switching leg Rw, and outputs a detection signal (W-phase voltage signal) indicating the W-phase voltage to the temperature estimation unit a1 and the gate signal generation unit a2 of the control device A.

Of the current sensors 13 to 15, the current sensor 13 is a sensor for detecting an output current (U-phase current) of the U-phase switching leg Ru and outputs a detection signal (U-phase current signal) indicating the U-phase current to the temperature estimation unit a1 and the gate signal generation unit a2 of the control device A. The current sensor 14 is a sensor for detecting an output current (V-phase current) of the V-phase switching leg Rv and outputs a detection signal (V-phase current signal) indicating the V-phase current to the temperature estimation unit a1 and the gate signal generation unit a2 of the control device A. The current sensor 15 is a sensor for detecting an output current (W-phase current) of the W-phase switching leg Rw and outputs a detection signal (W-phase current signal) indicating the W-phase current to the temperature estimation unit a1 and the gate signal generation unit a2 of the control device A.

The control device A estimates operating temperatures of the MOS transistors 1 to 6 on the basis of the power supply voltage signal of the voltage sensor 9, the U-phase voltage signal of the voltage sensor 10, the V-phase voltage signal of the voltage sensor 11, the W-phase voltage signal of the voltage sensor 12, the U-phase current signal of the current sensor 13, the V-phase current signal of the current sensor 14, and the W-phase current signal of the current sensor 15 described above, and generates gate signals on the basis of the values based on the estimation (estimated temperature values), and state quantities and control commands input from external equipment.

That is, the temperature estimation unit a1 of the control device A acquires the power supply voltage $V_D$ obtained from the voltage sensor 9, a U-phase voltage $V_u$, a V-phase voltage $V_v$, and a W-phase voltage $V_w$ obtained from the voltage sensors 10 to 12, and a U-phase current $I_u$, a V-phase current $I_v$, and a W-phase current $I_w$ obtained from the current sensors 13 to 15. Also, the temperature estimation unit a1 acquires junction temperatures $T_1$ to $T_6$ of the body diodes D1 to D6 on the basis of a state signal indicating a state of the gate signal input from the gate signal generation unit a2. A junction temperature of the body diode D1 is a junction temperature $T_1$. A junction temperature of the body diode D2 is a junction temperature $T_2$. A junction temperature of the body diode D3 is a junction temperature $T_3$. A junction temperature of the body diode D4 is a junction temperature $T_4$. A junction temperature of the body diode D5 is a junction temperature $T_5$. A junction temperature of the body diode D6 is a junction temperature $T_6$.

Here, the body diodes D1 to D6 and the six MOS transistors 1 to 6 have an integrated structure, and therefore are in a thermally close relationship. That is, the junction temperatures $T_1$ to $T_6$ relating to the body diodes D1 to D6 can be regarded as the operating temperatures of the MOS transistors 1 to 6. Therefore, the temperature estimation unit a1 acquires (estimates) the junction temperatures $T_1$ to $T_6$ as the operating temperatures of the MOS transistors 1 to 6.

That is, the temperature estimation unit a1 acquires the junction temperature $T_1$ of the first body diode D1 in the U-phase switching leg Ru on the basis of the power supply voltage signal of the voltage sensor 9, the U-phase voltage signal of the voltage sensor 10, and the U-phase current signal of the current sensor 13, and uses the junction temperature $T_1$ as the operating temperature of the MOS transistor 1 of the upper arm.

Also, the temperature estimation unit a1 acquires the junction temperature $T_2$ of the body diode D2 in the U-phase switching leg Ru on the basis of the U-phase voltage signal of the voltage sensor 10 and the U-phase current signal of the current sensor 13, and uses the junction temperature $T_2$ as the operating temperature of the MOS transistor 2 of the lower arm.

Also, the temperature estimation unit a1 acquires the junction temperature $T_3$ of the body diode D3 in the V-phase switching leg Rv on the basis of the power supply voltage signal of the voltage sensor 9, the V-phase voltage signal of the voltage sensor 11, and the V-phase current signal of the current sensor 14, and uses the junction temperature $T_3$ as the operating temperature of the MOS transistor 3 of the upper arm.

Also, the control device A acquires the junction temperature $T_4$ of the body diode D4 in the V-phase switching leg Rv on the basis of the V-phase voltage signal of the voltage sensor 11 and the V-phase current signal of the current sensor 14, and uses the junction temperature $T_4$ as the operating temperature of the MOS transistor 4 of the lower arm.

Also, the temperature estimation unit a1 acquires the junction temperature $T_5$ of the body diode D5 in the W-phase switching leg Rw on the basis of the power supply voltage signal of the voltage sensor 9, the W-phase voltage signal of the voltage sensor 12, and the W-phase current signal of the current sensor 15, and uses the junction temperature $T_5$ as the operating temperature of the MOS transistor 5 of the upper arm.

Also, the control device A acquires the junction temperature $T_6$ of the body diode D6 in the W-phase switching leg Rw on the basis of the W-phase voltage signal of the voltage sensor 12 and the W-phase current signal of the current sensor 15, and uses the junction temperature $T_6$ as the operating temperature of the MOS transistor 6 of the lower arm.

Here, as is well known, a forward current $I_F$ flowing through a junction portion (junction) of a pn junction diode follows the Shockley diode equation shown in the following equation (1). In equation (1), $I_S$ is a saturation current, $V_F$ is a forward voltage, q is an elementary charge amount, n is an ideality factor, $K_B$ is the Boltzmann constant, T is a junction temperature, and Rs is a series resistance of the junction diode. Of these physical quantities of various types, the saturation current $I_S$, the elementary charge amount q, the Boltzmann constant $K_B$, and the series resistance Rs of the junction diode are known constants.

[Equation 1]

$$I_F = I_S \left[\exp\left(\frac{qV_F - R_S I_F}{nK_B T}\right) - 1\right] \quad \cdots (1)$$

In equation (1), assuming that the first term in square brackets is sufficiently larger than 1 in the second term, equation (2) is established as an approximate equation. Then, if this approximate equation (2) is solved for the junction temperature T, equation (3) can be obtained.

[Equation 2]

$$I_F \fallingdotseq I_S exp\left(\frac{qV_F - R_S I_F}{nK_B T}\right) \quad \cdots (2)$$

[Equation 3]

$$T = \frac{qV_F - R_S I_F}{nK_B Ln\left(\frac{I_F}{I_S}\right)} \quad \cdots (3)$$

That is, it can be obtained by acquiring the forward currents $I_1$ to $I_6$ and forward voltages $V_{F1}$ to $V_{F6}$ of the body diodes D1 to D6. Of the forward currents $I_1$ to $I_6$ of the body diodes D1 to D6, the forward current $I_1$ of the body diode D1 and the forward current $I_2$ of the second body diode D2 related to the U-phase switching leg Ru correspond to the U-phase current $I_u$ detected by the current sensor 13.

The forward current $I_1$ is a forward current of the body diode D1. The forward voltage $V_{F1}$ is a forward voltage of the body diode D1. The forward current $I_2$ is a forward current of the body diode D2. The forward voltage $V_{F2}$ is a forward voltage of the body diode D2. The forward current $I_3$ is a forward current of the body diode D3. The forward voltage $V_{F3}$ is a forward voltage of the body diode D3. The forward current $I_4$ is a forward current of the body diode D4. The forward voltage $V_{F4}$ is a forward voltage of the body diode D3. The forward current $I_5$ is a forward current of the body diode D5. The forward voltage $V_{F5}$ is a forward voltage of the body diode D5. The forward current $I_6$ is a forward current of the body diode D6. The forward voltage $V_{F6}$ is a forward voltage of the body diode D6.

The forward current $I_3$ of the body diode D3 and the forward current $I_4$ of the body diode D4 related to the V-phase switching leg Rv correspond to the V-phase current $I_v$ detected by the current sensor 14. Further, the forward current $I_5$ of the body diode D5 and the forward current $I_6$ of the body diode D6 related to the W-phase switching leg Rw correspond to the W-phase current $I_w$ detected by the current sensor 15.

Of the forward voltages $V_{F1}$ to $V_{F6}$ of the body diodes D1 to D6, the forward voltages $V_{F2}$, $V_{F4}$, and $V_{F6}$ of the body diodes D2, D4, and D6 correspond to output voltages of the respective phases detected by the voltage sensors 10 to 12. Further, the forward voltages $V_{F1}$, $V_{F3}$, and $V_{F5}$ of the body diodes D1, D3, and D5 can be obtained by subtracting the forward voltages $V_{F2}$, $V_{F4}$, and $V_{F6}$ of the body diodes D2, D4, and D6 from the power supply voltage $V_D$ detected by the voltage sensor 9.

The temperature estimation unit a1 stores in advance map data representing such a relationship between the forward voltages $V_{F1}$ to $V_{F6}$, the forward currents $I_1$ to $I_6$, and the junction temperatures $T_1$ to $T_6$ of the body diodes D1 to D6, that is, a plurality of temperature data on the junction temperatures $T_1$ to $T_6$ based on equation (3).

When the temperature estimation unit a1 takes in the U-phase voltage $V_u$ corresponding to the forward voltage $V_{F2}$, the V-phase voltage $V_v$ corresponding to the forward voltage $V_{F4}$, and the W-phase voltage $V_w$ corresponding to the forward voltage $V_{F6}$ from the voltage sensors 10 to 12, and takes in the U-phase current $I_u$ corresponding to the forward currents $I_1$ and $I_2$, the V-phase current $I_v$ corresponding to the forward currents $I_3$ and $I_4$, and the W-phase current $I_w$ corresponding to the forward currents $I_5$ and $I_6$ from the current sensors 13 to 15, the temperature estimation unit a1 acquires the junction temperatures $T_1$ to $T_6$ by retrieving the above-described map data on the basis of the U-phase voltage $V_u$, the V-phase voltage $V_v$, the W-phase voltage $V_w$, the U-phase current $I_u$, the V-phase current $I_v$, and the W-phase current $I_w$.

Such a temperature estimation unit a1 corresponds to a temperature estimation device according to the present invention, and outputs the operating temperatures of the MOS transistors 1 to 6, that is, the junction temperatures $T_1$ to $T_6$ (estimated temperature values) of the body diodes D1 to D6 to the gate signal generation unit a2. The gate signal generation unit a2 generates gate signals for controlling the MOS transistors 1 to 6 on the basis of the operating temperatures of the MOS transistors 1 to 6, and state quantities and control commands input from external equipment.

Also, the gate signal generation unit a2 outputs the first gate signal to the gate terminal of the MOS transistor 1 of the upper arm and outputs the second gate signal to the gate terminal of the MOS transistor 2 of the lower arm. Also, the gate signal generation unit a2 outputs the third gate signal to the gate terminal of the MOS transistor 3 of the upper arm and outputs the fourth gate signal to the gate terminal of the MOS transistor 4 of the lower arm. Further, the gate signal generation unit a2 outputs the fifth gate signal to the gate terminal of the MOS transistor 5 of the upper arm and outputs the sixth gate signal to the gate terminal of the MOS transistor 6 of the lower arm.

Although details will be described later, the first gate signal and the second gate signal of the MOS transistor 1 of the upper arm and the MOS transistor 2 of the lower arm which form the U-phase switching leg Ru are paired with each other, and a dead time with a time width $\Delta t$ is provided at a transition point. The third gate signal and the fourth gate signal of the MOS transistor 3 of the upper arm and the MOS transistor 4 of the lower arm which form the V-phase switching leg Rv are paired with each other, and a dead time with a time width $\Delta t$ is provided at a transition point.

Further, the fifth gate signal and the sixth gate signal of the MOS transistor 5 of the upper arm and the MOS transistor 6 of the lower arm which form the W-phase switching leg Rw are paired with each other, and a dead time with a time width $\Delta t$ is provided at a transition point. Such a time width $\Delta t$ of the dead time is a predetermined value that has been set in advance and is for preventing a through current in the switching leg of each phase.

Here, of the above-described gate signals, the first, third, and fifth gate signals corresponding to the MOS transistors 1, 3, and 5 of the upper arm correspond to one gate signal, and the second, fourth, and sixth gate signals corresponding to the MOS transistors 2, 4, and 6 of the lower arm correspond to the other gate signal.

For such a dead time, in order to secure a sufficient estimation processing time of the junction temperatures $T_1$ to $T_6$ of the body diodes D1 to D6 in the temperature estimation unit a1, the gate signal generation unit a2 sets an extended time width in which the predetermined time width $\Delta t$ is temporarily extended when estimation processing of the junction temperatures $T_1$ to $T_6$ is performed. Further, details on the processing of extending the predetermined time width $\Delta t$ will be described later.

At the time of the processing of extending the predetermined time width $\Delta t$, the gate signal generation unit a2 refers to the U-phase voltage signal, the V-phase voltage signal, the W-phase voltage signal, the U-phase current signal, the V-phase current signal, and the W-phase current signal, and calculates an output power of the three-phase inverter circuit B on the basis of the U-phase voltage signal, the V-phase voltage signal, the W-phase voltage signal, the U-phase current signal, the V-phase current signal, and the W-phase current signal.

Further, the gate signal generation unit a2 outputs the above-described state signal to the temperature estimation unit a1. The state signal is a signal indicating a state of the gate signal, that is, an ON state (ON state) or an OFF state (OFF state), and therefore is a switch state signal indicating ON/OFF of each of the MOS transistors 1 to 6.

Next, an operation of the control device A according to the first embodiment will be described in detail with reference to FIGS. 2 to 4.

As shown in FIG. 2, the gate signal generation unit a2 described above first determines whether or not temperature estimation should be performed (step S1). For example, when the temperature estimation is periodically performed, the gate signal generation unit a2 determines a period for performing the temperature estimation on the basis of a temperature response time constant that it has grasped. The gate signal generation unit a2 refers to a value (timer value) of a timer that measures time, and determines whether or not the timer value has reached a preset value (execution time) as step S1.

If the determination in step S1 described above is "No", that is, if temperature estimation is not performed, the gate signal generation unit a2 generates a normal gate signal based on a control command and a state quantity and outputs them to the three-phase inverter circuit B (step S2). This normal gate signal is a signal for feedback-controlling the three-phase inverter circuit B on the basis of the control command and the state quantity, and is a signal that does not consider estimation processing for the operating temperature of the MOS transistors 1 to 6 performed by the temperature estimation unit a1 at all.

Here, FIG. 3 shows an example of the first gate signal and second gate signal input to the semiconductor switching elements of the U-phase upper arm and the U-phase lower arm, that is, the gate terminal of the MOS transistor 1 of the upper arm and the gate terminal of the MOS transistor 2 of the lower arm. FIG. 3 shows three types of the first gate signal and second gate signal, and waveforms shown in the second row and the third row from above correspond to the normal gate signals described above.

The gate signal generation unit a2 uses a triangular wave having a predetermined cycle period as a carrier wave as shown in the uppermost row of FIG. 3 and generates a gate signal by comparing a voltage command value generated on the basis of a control command and a state quantity with the carrier wave, but sets a dead time of the time width $\Delta t$ at a transition point of the gate signal to prevent a through current in the switching leg of each phase.

The dead time is a period during which the gate signal for the U-phase upper arm and the gate signal for the U-phase lower arm are both in an OFF state, and is set for each of a timing of transition from an OFF state to an ON state and a timing of transition from an ON state to an OFF state. Also, such a time width $\Delta t$ of the dead time is a preset value set in advance in consideration of performance of the semiconductor switching element, or the like.

Incidentally, if the determination in step S 1 described above is "Yes", that is, if temperature estimation is performed, processing of step S3 is performed. That is, the gate signal generation unit a2 determines whether or not the output power of the three-phase inverter circuit B is equal to or lower than a predetermined power threshold value Rw by comparing the output power of the three-phase inverter circuit B with the predetermined power threshold value Rw (step S3).

More specifically, the gate signal generation unit a2 calculates phase power of each phase on the basis of the U-phase voltage signal, the V-phase voltage signal, the W-phase voltage signal, the U-phase current signal, the V-phase current signal, and the W-phase current signal, and calculates the output power of the three-phase inverter circuit B on the basis of each phase power. Then, the gate signal generation unit a2 performs the determination processing of step S3 by comparing the output power calculated in this way with the power threshold value Rw stored in advance.

Then, if the determination in step S3 is "Yes," the gate signal generation unit a2 performs processing for shortening an ON pulse (ON pulse) in the normal gate signal described above (step S4). That is, the gate signal generation unit a2 extends the dead time from the predetermined time width $\Delta t$ to a time width $\Delta 2t$ (extended time width) by reducing the time width of the ON pulse in the second gate signal as shown in the fourth row and fifth row in FIG. 3.

On the other hand, if the determination in step S3 is "No", that is, if the output power of the three-phase inverter circuit B is larger than the power threshold value Rw, processing of removing the ON pulse in the above-described normal gate signal is performed (step S5). That is, as shown in the sixth row and seventh row of FIG. 3, the gate signal generation unit a2 extends the dead time from the predetermined time width $\Delta t$ to a time width $\Delta 6t$ (extended time width) by removing the ON pulse in the second gate signal.

In this way, the gate signal generation unit a2 switches a setting method of the dead time according to a magnitude of the output power of the three-phase inverter circuit B with respect to the power threshold value Rw. That is, if the output power of the three-phase inverter circuit B is equal to or lower than the power threshold value Rw, the gate signal generation unit a2 sets the time width $\Delta 2t$ (extended time width) of the dead time by making an ON time (ON time) of the second gate signal (the other gate signal) smaller than an ON time of the first gate signal (one gate signal), and, on the other hand, if the output power of the three-phase inverter circuit B is larger than the power threshold value Rw, the gate signal generation unit a2 sets the time width $\Delta 6t$ (extended time width) of the dead time by removing the ON pulse of the second gate signal (the other gate signal).

In FIG. 3, although the processing of extending the time width $\Delta t$ of the dead time relating to the U-phase, that is, the first gate signal for the MOS transistor 1 of the upper arm and the second gate signal for the MOS transistor 2 of the lower arm has been described here, similarly, the processing of extending the time width $\Delta t$ of the dead time is performed also for the V-phase and the W-phase, that is, the third gate signal for the MOS transistor 3 of the upper arm, the fourth gate signal for the MOS transistor 4 of the lower arm, the fifth gate signal for the MOS transistor 5 of the upper arm, and the sixth gate signal for the MOS transistor 6 of the lower arm.

When the gate signal generation unit a2 completes such processing of extending the time width $\Delta t$ of the dead time relating to the three phases, estimation processing of the operating temperatures of the MOS transistors 1 to 6 is executed in the extended time width, that is, the time width $\Delta 2t$ or the time width $\Delta 6t$ (step S6). The estimation processing of the operating temperatures is realized by the temperature estimation unit a1 executing a series of processing shown in FIG. 4.

Further, procedures for estimating the operating temperatures of the MOS transistors 1 to 6 in the U-phase, V-phase, and W-phase are basically the same. Therefore, a procedure for estimating the operating temperatures of the MOS transistor 1 of the upper arm and the MOS transistor 2 of the lower arm of the U phase will be described in detail below with reference to FIG. 4.

When the operating temperatures of the MOS transistor 1 of the upper arm and the MOS transistor 2 of the lower arm of the U phase are estimated, the temperature estimation unit a1 first determines whether a polarity of the U-phase current $I_u$ is positive or not on the basis of the U-phase current signal input from the current sensor 13 (step Sa1).

If the determination in step Sa1 is "Yes", that is, if the polarity of the U-phase current $I_u$ is positive, the temperature estimation unit a1 determines whether or not the MOS transistor 1 of the upper arm, which forms the U-phase upper arm, is in an OFF state on the basis of the state signal (switch state signal) input from the gate signal generation unit a2 (step Sa2).

Then, if the determination in step Sa2 is "Yes", that is, if the MOS transistor 1 of the upper arm is in an OFF state, the temperature estimation unit a1 determines whether or not the MOS transistor 2 of the lower arm, which forms the U-phase lower arm, is in an OFF state on the basis of the above-described state signal (switch state signal) (step Sa3).

If the determination in step Sa3 is "Yes", that is, in the dead time in which the MOS transistor 1 of the upper arm and the MOS transistor 2 of the lower arm are both in an OFF state as shown in FIG. 3, the temperature estimation unit a1 acquires the U-phase current $I_u$ (step Sa4), and acquires the U-phase voltage $V_u$ on the basis of the U-phase voltage signal input from the voltage sensor 10 (step Sa5).

Then, the temperature estimation unit a1 acquires map values corresponding to the U-phase current $I_u$ and the U-phase voltage $V_u$, that is, the junction temperature $T_2$ of the body diode D2 by retrieving the map data using the U-phase current $I_u$ and the U-phase voltage $V_u$ (step Sa6). Then, the temperature estimation unit a1 uses the junction temperature $T_2$ of the body diode D2 acquired in this way as the operating temperature of the MOS transistor 2 of the lower arm (step Sa7).

When the operating temperature of the MOS transistor 2 of the lower arm (the junction temperature $T_2$ of the body diode D2) is acquired in this way, the temperature estimation unit a1 determines whether or not the polarity of the U-phase current $I_u$ is negative on the basis of the U-phase current signal input from the current sensor 13 (step Sa8).

Then, if the determination in step Sa8 is "Yes", that is, if the polarity of the U-phase current $I_u$ is negative, the temperature estimation unit a1 determines whether or not the MOS transistor 1 of the upper arm, which forms the U-phase upper arm, is in an OFF state on the basis of the state signal (switch state signal) input from the gate signal generation unit a2 (step Sa9).

Then, if the determination in step Sa9 is "Yes", that is, if the MOS transistor 1 of the upper arm is in an OFF state, the temperature estimation unit a1 determines whether or not the MOS transistor 2 of the lower arm, which forms the U-phase lower arm, is in an OFF state on the basis of the above-described state signal (switch state signal) (step Sa10).

If the determination in step Sa10 is "Yes", that is, in the dead time in which the MOS transistor 1 of the upper arm and the MOS transistor 2 of the lower arm are both in an OFF state as shown in FIG. 3, the temperature estimation unit a1 acquires the U-phase current $I_u$ (step Sa11), and acquires a forward voltage Vi of the body diode D1 by subtracting the U-phase voltage $V_u$ acquired from the U-phase voltage signal input from the voltage sensor 10 from the power supply voltage $V_D$ (step Sa12).

Then, the temperature estimation unit a1 acquires map values corresponding to the U-phase current $I_u$ and the forward voltage Vi, that is, the junction temperature $T_1$ of the body diode D1 by retrieving the map data using the U-phase current $I_u$ and the forward voltage Vi (step Sa13). Then, the temperature estimation unit a1 uses the junction temperature $T_1$ of the body diode D1 acquired in this way as the operating temperature of the MOS transistor 1 of the lower arm (step Sa14).

Although, the temperature estimation unit a1 acquires the operating temperatures of the MOS transistor 1 of the upper arm and the MOS transistor 2 of the lower arm in this way, the temperature estimation unit a1 also performs similarly for the MOS transistor 3 of the upper arm and the MOS transistor 4 of the lower arm which form the V-phase switching leg Rv, and the MOS transistor 5 of the upper arm and the MOS transistor 6 of the lower arm which form the W-phase switching leg Rw.

That is, the temperature estimation unit a1 acquires operating temperatures of all the MOS transistors 1 to 6. Then, the temperature estimation unit a1 outputs such operating temperatures of the MOS transistors 1 to 6 to the gate signal generation unit a2.

If the operating temperatures of the MOS transistors 1 to 6 are within a preset allowable range, the gate signal generation unit a2 generates gate signals that control the MOS transistors 1 to 6 regardless of the operating temperatures of the MOS transistors 1 to 6. If the operating temperature of any of the MOS transistors 1 to 6 deviates from the allowable range, that is, if an abnormal temperature occurs in any of the MOS transistors, the gate signal generation unit a2 suppresses an output of the MOS transistor with the abnormal temperature to reduce heat generation by generating a gate signal for forcibly turning off the MOS transistor with the abnormal temperature.

According to the first embodiment, since the forward currents and the forward voltages of the body diodes D1 to D6 are acquired in the time width $\Delta 2t$ or the time width $\Delta 6t$ of the dead time, which has been extended to be longer than the time width $\Delta t$ of the dead time in a normal gate signal, to estimate the operating temperatures of the MOS transistors 1 to 6, the operating temperatures of the MOS transistors 1 to 6 (semiconductor switching elements) can be estimated without requiring a high-speed operation.

Also, according to the first embodiment, since the gate signals are generated on the basis of the operating temperatures of the MOS transistors 1 to 6 (semiconductor switching elements) obtained in the way, the MOS transistors 1 to 6 can be accurately controlled.

Further, the present invention is not limited to the first embodiment, and for example, the following modified example is conceivable.

In the first embodiment, the three-phase inverter circuit B (switching circuit) has been formed of the six MOS transistors 1 to 6 (semiconductor switching elements), but the present invention is not limited thereto. The present invention can also be applied to a three-phase inverter circuit formed using semiconductor switching elements of a form different from that of the MOS transistors such as an insulated gate bipolar transistor (IGBT).

For example, if an IGBT is employed as the semiconductor switching element, even with a reverse-conducting IGBT (RC-IGBT) integrated as a body diode, a temperature of the semiconductor switching element can be estimated from a junction temperature of the body diode estimated from a forward current and a forward voltage during operation in the same manner as the MOS transistor.

Also, even in an IGBT that does not have a body diode as a parasitic diode like the MOS transistor, it is necessary to provide the IGBT close enough to be affected by heat of the same DCB substrate or the like, but a temperature of the semiconductor switching element can be estimated from a junction temperature of a freewheeling diode estimated from a forward current and a forward voltage.

In the first embodiment, the three-phase inverter circuit B, which is a type of switching circuit, has been described, but the present invention can also be applied to switching circuits other than the three-phase inverter circuit B. The present invention can also be applied to, for example, switching circuits having one semiconductor switching element. That is, the present invention can be applied to estimation of an operating temperature of one or a plurality of semiconductor switching elements forming a switching circuit and each provided with a freewheeling diode.

In the first embodiment, operating temperatures of all the MOS transistors 1 to 6 (semiconductor switching elements) forming the three-phase inverter circuit B (switching circuit) have been estimated, but the present invention is not limited thereto. For example, the operating temperature of some of the MOS transistors 1 to 6 (semiconductor switching elements) may be estimated.

In the first embodiment, a case in which an implementation condition for temperature estimation is a time condition has been described, but the present invention is not limited thereto. That is, operating temperatures of the MOS transistors 1 to 6 may be estimated on the basis of implementation conditions other than the time condition.

(Second embodiment)

A second embodiment will be described below with reference to the drawings. In the following description, portions having functions similar to the contents described in the first embodiment are denoted by the same terms and reference signs, and detailed descriptions on the functions will be omitted.

A control device 100 according to the present embodiment is a device intended for controlling a three-phase inverter circuit X as illustrated in FIG. 5. The three-phase inverter circuit X is a switching circuit formed of six MOS transistors 1 to 6 as illustrated in the figure, converts DC power supplied from a DC power supply 7 into three-phase AC power, and supplies the three-phase AC power to a motor 8 (load).

Explaining the three-phase inverter circuit X in more detail, the three-phase inverter circuit X includes three switching legs Ru, Rv, and Rw corresponding to each of the phases. Of these switching legs Ru, Rv, and Rw, the switching leg Ru is a U-phase switching leg corresponding to a U-phase. The switching leg Rv is a V-phase switching leg corresponding to a V-phase. The switching leg Rw is a W-phase switching leg corresponding to a W-phase.

These three switching legs Ru, Rv, and Rw respectively include the MOS transistors 1, 3, and 5 forming upper arms and the MOS transistors 2, 4, and 6 forming lower arms. These six MOS transistors 1 to 6 correspond to semiconductor switching elements of the present invention.

That is, the U-phase switching leg Ru includes the MOS transistor 1 of the upper arm and the MOS transistor 2 of the lower arm. The V-phase switching leg Rv includes the MOS transistor 3 of the upper arm and the MOS transistor 4 of the lower arm. The W-phase switching leg Rw includes the MOS transistor 5 of the upper arm and the MOS transistor 6 of the lower arm.

Further explaining each of the switching leg Ru, Rv, and Rw, in the U-phase switching leg Ru, the MOS transistor 1 of the upper arm and the MOS transistor 2 of the lower arm are connected in series to the DC power supply 7.

That is, the MOS transistor 1 of the upper arm has a drain terminal connected to a positive electrode of the DC power supply 7, and a source terminal connected to a drain terminal of the MOS transistor 2 of the lower arm. The MOS transistor 2 of the lower arm has the drain terminal connected to the above-described source terminal of the MOS transistor 1 of the upper arm, and a source terminal connected to a negative electrode of the DC power supply 7.

Similarly to the U-phase switching leg Ru described above, the V-phase switching leg Rv includes the MOS transistor 3 of the upper arm and the MOS transistor 4 of the lower arm connected in series to the DC power supply 7.

That is, the MOS transistor 3 of the upper arm has a drain terminal connected to the positive electrode of the DC power supply 7 and a source terminal connected to a drain terminal of the MOS transistor 4 of the lower arm. The MOS transistor 4 of the lower arm has the drain terminal connected to the above-described source terminal of the MOS transistor 3 of the upper arm, and a source terminal connected to the negative electrode of the DC power supply 7.

Similarly to the U-phase switching leg Ru and the V-phase switching leg Rv described above, the W-phase switching leg Rw includes the MOS transistor 5 of the upper arm and the MOS transistor 6 of the lower arm connected in series to the DC power supply 7.

That is, the MOS transistor 5 of the upper arm has a drain terminal connected to the positive electrode of the DC power supply 7, and a source terminal connected to a drain terminal of the MOS transistor 6 of the lower arm. The MOS transistor 6 of the lower arm has the drain terminal connected to the above-described source terminal of the MOS transistor 5 of the upper arm, and a source terminal connected to the negative electrode of the DC power supply 7.

Also, in the U-phase switching leg Ru, the source terminal of the MOS transistor 1 of the upper arm and the drain terminal of the MOS transistor 2 of the lower arm connected to each other serve as an output end of the U-phase switching leg Ru. This output end is a U-phase output end of the three-phase inverter circuit X and is connected to a U-phase input end of the motor 8.

Also, in the V-phase switching leg Rv, the source terminal of the MOS transistor 3 of the upper arm and the drain terminal of the MOS transistor 4 of the lower arm connected to each other serve as an output end of the V-phase switching leg Rv. This output end is a V-phase output end of the three-phase inverter circuit X and is connected to a V-phase input end of the motor 8.

Further, in the W-phase switching leg Rw, the source terminal of the MOS transistor 5 of the upper arm and the drain terminal of the MOS transistor 6 of the lower arm connected to each other serve as an output end of the W-phase switching leg Rw. This output end is a W-phase output end of the three-phase inverter circuit X and is connected to a W-phase input end of the motor 8.

Body diodes D1 to D6 are collaterally provided to such six MOS transistors 1 to 6 forming the three-phase inverter circuit X. The body diodes D1 to D6 function as freewheeling diodes that return a regenerated current based on a counter-electromotive force of the motor 8 to the DC power supply 7.

That is, the MOS transistor 1 of the upper arm of the U-phase switching leg Ru has the body diode D1. As illustrated in the figure, the body diode D1 has a cathode terminal connected to the drain terminal of the MOS transistor 1 of the upper arm, and an anode terminal connected to the source terminal of the MOS transistor 1 of the upper arm.

Also, the MOS transistor 2 of the lower arm of the U-phase switching leg Ru has the body diode D2. As illustrated in the figure, the body diode D2 has a cathode terminal connected to the drain terminal of the MOS transistor 2 of the lower arm, and an anode terminal connected to the source terminal of the MOS transistor 2 of the lower arm.

The MOS transistor 3 of the upper arm of the V-phase switching leg Rv has the body diode D3. As illustrated in the figure, the body diode D3 has a cathode terminal connected to the drain terminal of the MOS transistor 3 of the upper arm, and an anode terminal connected to the source terminal of the MOS transistor 3 of the upper arm.

Also, the MOS transistor 4 of the lower arm of the V-phase switching leg Rv has the body diode D4. As illustrated in the figure, the body diode D4 has a cathode terminal connected to the drain terminal of the MOS transistor 4 of the lower arm, and an anode terminal connected to the source terminal of the MOS transistor 4 of the lower arm.

The MOS transistor 5 of the upper arm of the W-phase switching leg Rw has the body diode D5. As illustrated in the figure, the body diode D5 has a cathode terminal connected to the drain terminal of the MOS transistor 5 of the upper arm, and an anode terminal connected to the source terminal of the MOS transistor 5 of the upper arm.

Also, the MOS transistor 6 of the lower arm of the W-phase switching leg Rw has the body diode D6. As illustrated in the figure, the body diode D6 has a cathode terminal connected to the drain terminal of the MOS transistor 6 of the lower arm, and an anode terminal connected to the source terminal of the MOS transistor 6 of the lower arm.

Also, ON/OFF states of the MOS transistors 1 to 6 in such a three-phase inverter circuit X are each set on the basis of a gate signal input from the control device 100. The gate signal is a pulse width modulation (PWM) signal generated by the control device 100 for each of the MOS transistors 1 to 6.

Four voltage sensors 9 to 12 and three current sensors 13 to 15 are collaterally provided in such a three-phase inverter circuit X. Of the four voltage sensors 9 to 12, the voltage sensor 9 is a sensor for detecting an input voltage of the three-phase inverter circuit X, that is, an output voltage (power supply voltage $V_D$) of the DC power supply 7, and outputs a detection signal (power supply voltage signal) indicating the power supply voltage $V_D$ to the control device 100.

The voltage sensor 10 is a sensor for detecting an output voltage (U-phase voltage) of the U-phase switching leg Ru, and outputs a detection signal (U-phase voltage signal) indicating the U-phase voltage to the control device 100. The voltage sensor 11 is a sensor for detecting an output voltage (V-phase voltage) of the V-phase switching leg Rv, and outputs a detection signal (V-phase voltage signal) indicating the V-phase voltage to the control device 100. The voltage sensor 12 is a sensor for detecting an output voltage (W-phase voltage) of the W-phase switching leg Rw, and outputs a detection signal (W-phase voltage signal) indicating the W-phase voltage to the control device 100.

Of the three current sensors 13 to 15, the current sensor 13 is a sensor for detecting an output current (U-phase current) of the U-phase switching leg Ru and outputs a detection signal (U-phase current signal) indicating the U-phase current to the control device 100. The current sensor 14 is a sensor for detecting an output current (V-phase current) of the V-phase switching leg Rv and outputs a detection signal (V-phase current signal) indicating the V-phase current to the control device 100. The current sensor 15 is a sensor for detecting an output current (W-phase current) of the W-phase switching leg Rw and outputs a detection signal (W-phase current signal) indicating the W-phase current to the control device 100.

The control device 100 estimates operating temperatures of the MOS transistors 1 to 6 on the basis of the power supply voltage signal, the U-phase voltage signal, the V-phase voltage signal, the W-phase voltage signal, the U-phase current signal, the V-phase current signal, and the W-phase current signal described above, and controls the three-phase inverter circuit X on the basis of the values based on the estimation (estimated temperature values), and state quantities and control commands input from external equipment.

That is, the control device 100 includes a temperature estimation unit 16 and a gate signal generation unit 17. When the body diodes D1 to D6 each operate in a linear region, the temperature estimation unit 16 calculates junction temperatures $T_1$ to $T_6$ of the body diodes D1 to D6 as operating temperatures of the MOS transistors 1 to 6 on the basis of the power supply voltage $V_D$ acquired from the voltage sensor 9, the U-phase voltage $V_u$, the V-phase voltage $V_v$, and the W-phase voltage $V_w$ acquired from the voltage sensors 10 to 12, the U-phase current $I_u$, the V-phase current $I_v$, and the W-phase current $I_w$ acquired from the current sensors 13 to 15, and a state signal indicating a state of the gate signal input from the gate signal generation unit 17.

Here, the body diodes D1 to D6 and the MOS transistors 1 to 6 have an integrated structure, and therefore are in a thermally close relationship. That is, the junction temperatures $T_1$ to $T_6$ relating to the body diodes D1 to D6 can be regarded as the operating temperatures of the MOS transistors 1 to 6. Therefore, the temperature estimation unit 16 acquires (estimates) the junction temperatures $T_1$ to $T_6$ as the operating temperatures of the MOS transistors 1 to 6.

That is, the temperature estimation unit 16 estimates the junction temperature $T_1$ of the body diode D1 in the U-phase switching leg Ru as the operating temperature of the MOS transistor 1 of the upper arm on the basis of the power supply voltage signal, the U-phase voltage signal, and the U-phase current signal. Also, the control device 100 estimates the junction temperature $T_2$ of the body diode D2 in the U-phase switching leg Ru as the operating temperature of the MOS transistor 2 of the lower arm on the basis of the U-phase voltage signal and the U-phase current signal.

Also, the temperature estimation unit 16 estimates the junction temperature $T_3$ of the body diode D3 in the V-phase switching leg Rv as the operating temperature of the MOS transistor 3 of the upper arm on the basis of the power supply voltage signal, the V-phase voltage signal, and the V-phase current signal. Also, the control device 100 estimates

the junction temperature $T_4$ of the body diode D4 in the V-phase switching leg Rv as the operating temperature of the MOS transistor 4 of the lower arm on the basis of the V-phase voltage signal and the V-phase current signal.

Further, the temperature estimation unit 16 estimates the junction temperature $T_5$ of the body diode D5 in the W-phase switching leg Rw as the operating temperature of the MOS transistor 5 of the upper arm on the basis of the power supply voltage signal, the W-phase voltage signal, and the W-phase current signal. Also, the control device 100 estimates the junction temperature $T_6$ of the body diode D6 in the W-phase switching leg Rw as the operating temperature of the MOS transistor 6 of the lower arm on the basis of the W-phase voltage signal and the W-phase current signal.

Here, a forward current $I_F$ flowing through a junction portion (junction) of a pn junction diode follows the Shockley diode equation shown in the above equation (1). In the above equation (1), assuming that the first term in square brackets is sufficiently larger than 1, the above equation (2) is established as an approximate equation. Then, if equation (2) is solved for the junction temperature T, equation (3) can be obtained.

When a relationship between the forward current $I_F$ and a forward voltage VF is graphed using the junction temperature T as a parameter on the basis of the above equation (3), the relationship is represented as shown in FIG. 6. Here, since the forward current $I_F$ is incorporated in equation (3) as a variable of natural logarithm, FIG. 6 is a logarithmic graph in which the vertical axis (current axis) is displayed logarithmically.

As shown in FIG. 6, in a current region in which the forward voltage VF and a logarithmic value of the forward current $I_F$ are in a linear relationship, the forward current $I_F$ is equal to or less than a current threshold value Ri. In a current region in which the forward current $I_F$ exceeds the current threshold value Ri, a voltage drop occurs due to a series resistance $R_S$ of the pn junction diode, and linearity between the forward voltage VF and the logarithmic value of the forward current $I_F$ deteriorates significantly.

Considering such a relationship between the forward voltage VF and the logarithmic value of the forward current $I_F$ with the junction temperature T as a parameter, in a case of trying to determine (estimate) the junction temperature T (parameter) on the basis of the forward voltage VF and the forward current $I_F$, in order to improve an estimation accuracy thereof, the linear region in the relationship between the forward voltage VF and the logarithmic value of the forward current $I_F$, that is, the current region in which the forward current $I_F$ is equal to or less than the current threshold value Ri is preferable.

That is, it can be obtained by obtaining forward currents $I_1$ to $I_6$ and forward voltages $V_{F1}$ to $V_{F6}$ of the body diodes D1 to D6. Of the forward currents $I_1$ to $I_6$ of the body diodes D1 to D6, the forward current $I_1$ of the body diode D1 and the forward current $I_2$ of the body diode D2 related to the U-phase switching leg Ru correspond to the U-phase current $I_u$ detected by the current sensor 13.

Also, the forward current $I_3$ of the body diode D3 and the forward current $I_4$ of the body diode D4 related to the V-phase switching leg Rv correspond to the V-phase current $I_v$ detected by the current sensor 14. Further, the forward current $I_5$ of the body diode D5 and the forward current $I_6$ of the body diode D6 related to the W-phase switching leg Rw correspond to the W-phase current $I_w$ detected by the current sensor 15.

Of the forward voltages $V_{F1}$ to $V_{F6}$ of the body diodes D1 to D6, the forward voltages $V_{F2}$, $V_{F4}$, and $V_{F6}$ of the three body diodes D2, D4, and D6 are output voltages of the respective phases detected by the voltage sensors 10 to 12. Further, the forward voltages $V_{F1}$, $V_{F3}$, and $V_{F5}$ of the three body diodes D1, D3, and D5 can be obtained by subtracting the forward voltages $V_{F2}$, $V_{F4}$, and $V_{F6}$ of the body diodes D2, D4, and D6 from the power supply voltage $V_D$ detected by the voltage sensor 10.

The temperature estimation unit 16 stores map data representing such a relationship between the forward voltages $V_{F1}$ to $V_{F6}$, the forward currents $I_1$ to $I_6$, and the junction temperatures $T_1$ to $T_6$ of the body diodes D1 to D6, that is, a plurality of temperature data on the junction temperatures $T_1$ to $T_6$ based on equation (3).

When the temperature estimation unit 16 takes in the U-phase voltage $V_u$ corresponding to the forward voltage $V_{F2}$, the V-phase voltage $V_v$ corresponding to the forward voltage $V_{F4}$, and the W-phase voltage $V_w$ corresponding to the forward voltage $V_{F6}$ from the voltage sensors 10 to 12, and takes in the U-phase current $I_u$ corresponding to the forward currents $I_1$ and $I_2$, the V-phase current $I_v$ corresponding to the forward currents $I_3$ and $I_4$, and the W-phase current $I_w$ corresponding to the forward currents $I_5$ and $I_6$ from the current sensors 13 to 15, the temperature estimation unit 16 acquires the junction temperatures $T_1$ to $T_6$ by retrieving the above-described map data on the basis of the U-phase voltage $V_u$, the V-phase voltage $V_v$, the W-phase voltage $V_w$, the U-phase current $I_u$, the V-phase current $I_v$, and the W-phase current $I_w$.

Also, the temperature estimation unit 16 takes in the above-described U-phase voltage $V_u$ (forward voltage $V_{F2}$), the V-phase voltage $V_v$ (forward voltage $V_{F4}$), the W-phase voltage $V_w$ (forward voltage $V_{F6}$), the U-phase current $I_u$, the V-phase current $I_v$, and the W-phase current $I_w$ in a state in which the body diodes D1 to D6 are operating in the linear region.

The linear region described above is an operating region in which the U-phase voltage $V_u$ (forward voltage $V_{F2}$) and the U-phase current $I_1$ are in a linear relationship, an operating region in which the V-phase voltage $V_v$ (forward voltage $V_{F4}$) and the U-phase current $I_2$ are in a linear relationship, an operating region in which the W-phase voltage $V_w$ (forward voltage $V_{F6}$) and the W-phase current $I_3$ are in a linear relationship, and an operating region in which the

U-phase current $I_u$, the V-phase current $I_v$, and the W-phase current $I_w$ are smaller than the predetermined current threshold value Ri.

Such a temperature estimation unit 16 corresponds to a temperature estimation device according to the present invention, and outputs the operating temperatures of the MOS transistors 1 to 6, that is, the junction temperatures $T_1$ to $T_6$ (estimated temperature values) of the body diodes D1 to D6, to the gate signal generation unit 17. The gate signal generation unit 17 generates first to sixth gate signals for controlling the six MOS transistors 1 to 6 on the basis of the operating temperatures of the MOS transistors 1 to 6, and state quantities and control commands input from external equipment.

Also, the gate signal generation unit 17 outputs the first gate signal to the gate terminal of the MOS transistor 1 of the upper arm and outputs the second gate signal to the gate terminal of the MOS transistor 2 of the lower arm. Also, the gate signal generation unit 17 outputs the third gate signal to the gate terminal of the MOS transistor 3 of the upper arm and outputs the fourth gate signal to the gate terminal of the MOS transistor 4 of the lower arm. Further, the gate signal generation unit 17 outputs the fifth gate signal to the gate terminal of the MOS transistor 5 of the upper arm and outputs the sixth gate signal to the gate terminal of the MOS transistor 6 of the lower arm.

Also, the gate signal generation unit 17 also outputs the state signal described above to the temperature estimation unit 16.

The state signal is a signal indicating a state of each of the first to sixth gate signals, that is, an ON state or an OFF state, and therefore is a switch state signal indicating ON/OFF of each of the MOS transistors 1 to 6.

Next, an operation of the control device 100 according to the second embodiment will be described in detail with reference to FIGS. 7 to 9.

The temperature estimation unit 16 (temperature estimation device) in the control device 100 estimates the operating temperature of each of the MOS transistors 1 to 6 in order of the U-phase temperature estimation (step S11), the V-phase temperature estimation (step S12), and the W-phase temperature estimation (step S13) as shown in FIG. 7.

That is, the temperature estimation unit 16 estimates the operating temperatures of all the MOS transistors 1 to 6 in the three-phase inverter circuit X (switching circuit) on the basis of the above equation (3) by obtaining all the junction temperatures $T_1$ to $T_6$ in order of the junction temperatures $T_1$ and $T_2$ of the body diodes D1 and D2, the junction temperatures $T_3$ and $T_4$ of the body diodes D3 and D4, and the junction temperatures $T_5$ and $T_6$ of the body diodes D5 and D6.

Here, procedures for estimating the operating temperatures of the MOS transistors 1 to 6 in the U-phase, the V-phase, and the W-phase are basically the same. Therefore, a procedure for estimating the operating temperatures of the MOS transistor 1 of the upper arm and the MOS transistor 2 of the lower arm of the U phase will be described in detail below with reference to FIG. 8.

When the operating temperatures of the MOS transistor 1 of the upper arm and the MOS transistor 2 of the lower arm of the U phase are estimated, the temperature estimation unit 16 first determines whether a polarity of the U-phase current $I_u$ is positive or not on the basis of the U-phase current signal input from the current sensor 13 (step Sb1).

If the determination in step Sb1 is "Yes", that is, if the polarity of the U-phase current $I_u$ is positive, the temperature estimation unit 16 determines whether or not the MOS transistor 1 of the upper arm, which forms the U-phase upper arm, is in an OFF state on the basis of the state signal (switch state signal) input from the gate signal generation unit 17 (step Sb2).

Then, if the determination in step Sb2 is "Yes", that is, if the MOS transistor 1 of the upper arm is in an OFF state, the temperature estimation unit 16 determines whether or not the MOS transistor 2 of the lower arm, which forms the U-phase lower arm, is in an OFF state on the basis of the above-described state signal (switch state signal) (step Sb3).

If the determination in step Sb3 is "Yes", that is, if the MOS transistor 1 of the upper arm and the MOS transistor 2 of the lower arm are both in an OFF state, the temperature estimation unit 16 determines whether or not an absolute value of the U-phase current $I_u$ is equal to or less than the current threshold value Ri on the basis of the U-phase current signal (step Sb4).

Here, FIG. 9 is a timing chart showing operating states of the MOS transistors 1 to 6 in the three-phase inverter circuit X, a carrier wave (triangular wave) that determines a cycle period of the gate signal, and a temporal change of the phase currents $I_u$ to $I_w$. A state in which the MOS transistor 1 of the upper arm and the MOS transistor 2 of the lower arm described above are both OFF corresponds to periods $\Delta p1$ to $\Delta p6$ in FIG. 9.

These periods $\Delta p1$ to $\Delta p6$ are dead times set by the gate signal generation unit 17 to prevent a through current from flowing in the U-phase switching leg Ru, the V-phase switching leg Rv, and the W-phase switching leg Rw. In the three-phase inverter circuit X, abnormal heat generation of the MOS transistors 1 to 6 due to the through current prevented by providing such a dead time for each of the U-phase switching leg Ru, the V-phase switching leg Rv, and the W-phase switching leg Rw.

Also, of these periods $\Delta p1$ to $\Delta p6$, the periods $\Delta p1$ to $\Delta p3$ are time regions in which the absolute value of the U-phase current $I_u$ is equal to or less than the current threshold value Ri. That is, the periods $\Delta p1$ to $\Delta p3$ are time regions in which a return current flows in the body diode D2 of the MOS transistor 2 of the lower arm as the U-phase current $I_u$.

Also, the periods $\Delta p1$ to $\Delta p3$ are included in a linear region in which the above-described return current relatively small in the operating region of the body diode D2.

The temperature estimation unit 16 acquires the U-phase current $I_u$ in such periods $\Delta p1$ to $\Delta p3$ (step Sb5), and acquires the U-phase voltage $V_u$ on the basis of the U-phase voltage signal input from the voltage sensor 10 (step Sb6). These U-phase current $I_u$ and U-phase voltage $V_u$ are characteristic quantities when the body diode D2 is operating in the linear region, and have excellent linearity in their mutual relationship.

Then, the temperature estimation unit 16 acquires map values corresponding to the U-phase current $I_u$ and the U-phase voltage $V_u$, that is, the junction temperature $T_2$ of the body diode D2 by retrieving the map data using the U-phase current $I_u$ and the U-phase voltage $V_u$ (step Sb7). Then, the temperature estimation unit 16 uses the junction temperature $T_2$ of the body diode D2 acquired in this way as the operating temperature of the MOS transistor 2 of the lower arm (step Sb8).

When the operating temperature of the MOS transistor 2 of the lower arm (the junction temperature $T_2$ of the body diode D2) is acquired in this way, the temperature estimation unit 16 determines whether or not the polarity of the U-phase current $I_u$ is negative on the basis of the U-phase current signal input from the current sensor 13 (step Sb9).

Then, if the determination in step Sb9 is "Yes", that is, if the polarity of the U-phase current $I_u$ is negative, the temperature estimation unit 16 determines whether or not the MOS transistor 1 of the upper arm, which forms the U-phase upper arm, is in an OFF state on the basis of the state signal (switch state signal) input from the gate signal generation unit 17 (step Sb10).

Then, if the determination in step Sb10 is "Yes", that is, if the MOS transistor 1 of the upper arm is in an OFF state, the temperature estimation unit 16 determines whether or not the MOS transistor 2 of the lower arm, which forms the U-phase lower arm, is in an OFF state on the basis of the above-described state signal (switch state signal) (step Sb11).

If the determination in step Sb11 is "Yes", that is, if the MOS transistor 1 of the upper arm and the MOS transistor 2 of the lower arm are both in an OFF state, the temperature estimation unit 16 determines whether or not the absolute value of the U-phase current $I_u$ is equal to or less than the current threshold value Ri on the basis of the U-phase current signal input from the current sensor 13 (step Sb12).

Here, although not shown in FIG. 9, a period $\Delta px$ in which the absolute value of the U-phase current $I_u$ is equal to or less than the current threshold value Ri is always present in the dead time in which the MOS transistor 1 of the upper arm and the MOS transistor 2 of the lower arm are both in an OFF state.

The period $\Delta px$ is a time region in which the return current flows in the body diode D1 of the MOS transistor 1 of the upper arm as the U-phase current $I_u$, and is included in a linear region in which the above-described return current relatively small in the operating region of the body diode D1.

The temperature estimation unit 16 acquires the U-phase current $I_u$ in such a period $\Delta px$ (step Sb13), and acquires a forward voltage Vi of the body diode D1 by subtracting the U-phase voltage $V_u$, which is acquired from the U-phase voltage signal input from the voltage sensor 10, from the power supply voltage $V_D$ (step Sb14). These U-phase current $I_u$ and forward voltage Vi are characteristic quantities when the body diode D1 is operating in the linear region, and have excellent linearity in their mutual relationship.

Then, the temperature estimation unit 16 acquires map values corresponding to the U-phase current $I_u$ and the forward voltage Vi, that is, the junction temperature $T_1$ of the body diode D1 by retrieving the map data using the U-phase current $I_u$ and the forward voltage Vi (step Sb15). Then, the temperature estimation unit 16 uses the junction temperature $T_1$ of the body diode D1 acquired in this way as the operating temperature of the MOS transistor 1 of the lower arm (step Sb16).

The temperature estimation unit 16 acquires operating temperatures of all the MOS transistors 1 to 6 by performing the processing of steps S11 to S13 in FIG. 7. Then, the temperature estimation unit 16 outputs such operating temperatures of the MOS transistors 1 to 6 to the gate signal generation unit 17.

If the operating temperatures of the MOS transistors 1 to 6 are within a preset allowable range, the gate signal generation unit 17 generates the first to sixth gate signals that control the MOS transistors 1 to 6 regardless of the operating temperatures of the MOS transistors 1 to 6, but if the operating temperature of any of the MOS transistors 1 to 6 deviates from the allowable range, that is, if an abnormal temperature occurs in any of the MOS transistors, the gate signal generation unit generates a gate signal for forcibly turning off the MOS transistor with the abnormal temperature.

According to the second embodiment, since the junction temperatures $T_1$ to $T_6$ of the body diodes D1 to D6 are estimated using the forward current and forward voltage when the body diodes D1 to D6 are operating in the linear region, and the junction temperatures $T_1$ to $T_6$ are used as the operating temperatures of the MOS transistors 1 to 6, the operating temperatures of the MOS transistors 1 to 6 (semiconductor switching elements) can be estimated with higher accuracy than in conventional cases.

Also, according to the second embodiment, since the first to sixth gate signals are generated on the basis of the operating temperatures of the MOS transistors 1 to 6 (semiconductor switching elements) obtained in the way, the MOS transistors 1 to 6 can be accurately controlled.

Further, the present invention is not limited to the above-described embodiments, and for example, the following modified example is conceivable.

In the second embodiment described above, the three-phase inverter circuit X (switching circuit) has been formed of the six MOS transistors 1 to 6 (semiconductor switching elements), but the present invention is not limited thereto. The present invention can also be applied to a three-phase inverter circuit formed using semiconductor switching elements having a form different from that of the MOS transistors such as insulated gate bipolar transistors (IGBTs).

Further, for example, if an IGBT is employed as the semiconductor switching element, even with a reverse-conducting IGBT (RC-IGBT) integrated as a body diode, a temperature of the semiconductor switching element can be estimated from a junction temperature of the body diode estimated from a forward current and a forward voltage during operation in the same manner as the MOS transistor. Also, even in an IGBT that does not have a body diode as a parasitic diode like the MOS transistor, it is necessary to provide the IGBT close enough to be affected by heat of the same DCB substrate or the like, but a temperature of the semiconductor switching element can be estimated from a junction temperature of a freewheeling diode estimated from a forward current and a forward voltage.

In the second embodiment described above, the three-phase inverter circuit X, which is a type of switching circuit, has been described, but the present invention can also be applied to switching circuits other than the three-phase inverter circuit X. The present invention can also be applied to, for example, switching circuits having one semiconductor switching element. That is, the present invention can be applied to estimation of an operating temperature of one or a plurality of semiconductor switching elements forming a switching circuit and each provided with a freewheeling diode.

In the second embodiment described above, operating temperatures of all the MOS transistors 1 to 6 (semiconductor switching elements) forming the three-phase inverter circuit X (switching circuit) have been estimated, but the present invention is not limited thereto. For example, the operating temperature of some of the MOS transistors (semiconductor switching elements) may be estimated on the basis of heat dissipation performance of a plurality (six) of MOS transistors 1 to 6 (semiconductor switching elements).

FIG. 10 schematically illustrates a cooling structure of the three-phase inverter circuit X (switching circuit) in the second embodiment. As illustrated in FIG. 10, each of the MOS transistors 1 to 6 is a heat-generating component configured as a semiconductor module, and a cooling jacket C is attached via a heat sink or the like.

That is, heat generated by each of the MOS transistors 1 to 6 is exhausted by being thermally conducted to a coolant flowing in the cooling jacket C via a heat sink or the like. Each of the MOS transistors 1 to 6 is maintained within a predetermined operating temperature by continuous exhaust of heat by the cooling jacket C.

Here, the above-described coolant flows into the cooling jacket C from an inlet c1 provided at one end of the cooling jacket C, and is discharged to the outside of the cooling jacket C from an outlet c2 provided at the other end of the cooling jacket C. That is, an overall flow direction of the coolant in the cooling jacket C is a direction from the inlet c1, that is, one end of the cooling jacket C, toward the outlet c2, that is, the other end of the cooling jacket C, as indicated by an arrow.

In such a cooling structure of the three-phase inverter circuit X, of the plurality of the (six) MOS transistors 1 to 6, that is, the U-phase switching leg Ru, the V-phase switching leg Rv, and the W-phase switching leg Rw, the U-phase switching leg Ru closest to the inlet c1 has the highest heat dissipation performance, and the W-phase switching leg Rw closest to the outlet c2 has the lowest heat dissipation performance.

That is, the heat dissipation performance of the three-phase inverter circuit X has a relationship of U-phase switching leg Ru > V-phase switching leg Rv > W-phase switching leg Rw. As a result, operating temperatures of the MOS transistor 5 of the upper arm and the MOS transistor 6 of the lower arm in the W-phase switching leg Rw tend to be higher than operating temperatures of the MOS transistors 1 and 3 of the upper arms and the MOS transistors 2 and 4 of the lower arms in switching legs of other phases.

Considering such a tendency on the operating temperatures of the MOS transistors 1 to 6, it is conceivable to estimate the operating temperatures of only the MOS transistor 5 of the upper arm and the MOS transistor 6 of the lower arm of the W-phase switching leg Rw as the operating temperature of some of the MOS transistors.

According to such a modified example, since the operating temperature of some of the MOS transistors is estimated instead of estimating the operating temperatures of all the MOS transistors 1 to 6, a processing load of the temperature estimation unit 16 on estimation of the operating temperatures of the MOS transistors can be reduced.

In the second embodiment described above, the operating temperatures of all the MOS transistors 1 to 6 have been estimated in order of the U-phase temperature estimation, the V-phase temperature estimation, and the W-phase temperature estimation as shown in FIG. 7, but the present invention is not limited thereto. As described above, in relation to the heat dissipation performance of the three-phase inverter circuit X, a phase that tends to have a higher operating temperature than other phases may be present among the phases. Considering this point, it is preferable to estimate the operating temperature in order from the phase that tends to have a higher operating temperature.

The first embodiment described above may include the configuration described in the second embodiment. For example, the temperature estimation unit a1 of the first embodiment may further have the function of the temperature estimation unit 16 of the second embodiment. As an example, the temperature estimation unit a1 may have a function of estimating the operating temperature of the semiconductor switching element on the basis of the forward voltage and the forward current of the freewheeling diode obtained from the switching circuit when the freewheeling diode operates in the linear region.

[Reference Signs List]

A, 100 Control device
a1, 16 Temperature estimation unit
a2, 17 Gate signal generation unit
B, X Three-phase inverter circuit (switching circuit)
D1 to D6 Body diode (freewheeling diode)
Ru U-phase switching leg
Rv V-phase switching leg
Rw W-phase switching leg
1, 3, 5 MOS transistor (semiconductor switching element) of upper arm
2, 4, 6 MOS transistor (semiconductor switching element) of lower arm
7 DC power supply
8 Motor
9 to 12 Voltage sensor
13 to 15 Current sensor
C Cooling jacket
c1 Inlet
c2 Outlet

## Claims

**1.** A temperature estimation device configured to estimate operating temperatures of an upper arm and a lower arm in an inverter circuit, the inverter circuit including one or a plurality of switching legs, each switching leg comprising semiconductor switching elements of the upper arm and the lower arm, each of the upper arm and the lower being provided with a freewheeling diode, wherein
the temperature estimation device configured to estimate the operating temperature on the basis of a forward voltage and a forward current of the freewheeling diode acquired from the inverter circuit in an extended time width, the extended time width in which a dead time between the upper arm and the lower arm is extended to be longer than a predetermined time width.

**2.** The temperature estimation device according to claim 1, wherein
of one and the other gate signals respectively controlling the upper arm and the lower arm, the extended time width is set by causing an ON time of the other gate signal to be smaller than an ON time of one gate signal.

**3.** The temperature estimation device according to claim 1, wherein
of one and the other gate signals respectively controlling the upper arm and the lower arm, the extended time width is set by removing an ON pulse of the other gate signal.

**4.** The temperature estimation device according to any one of claims 1 to 3, wherein
the operating temperature of the semiconductor switching element is estimated on the basis of the forward voltage and the forward current of the freewheeling diode acquired from the inverter circuit when the freewheeling diode operates in a linear region.

**5.** The temperature estimation device according to any one of claims 1 to 4, wherein

the inverter circuit is a three-phase inverter circuit having three switching legs provided therein, and
the operating temperature is estimated on the basis of the forward voltage and the forward current obtained from the three-phase inverter circuit.

**6.** The temperature estimation device according to any one of claims 1 to 5, wherein

when the inverter circuit comprises a plurality of semiconductor switching elements, the operating temperature of some of the semiconductor switching elements is estimated on the basis of heat dissipation performance of the plurality of the semiconductor switching elements.

**7.** A control device comprising:

the temperature estimation device according to any one of claims 1 to 6; and
a gate signal generation unit configured to generate a gate signal, the gate signal controlling the upper arm and the lower arm on the basis of the operating temperature estimated by the temperature estimation device.

FIG. 1

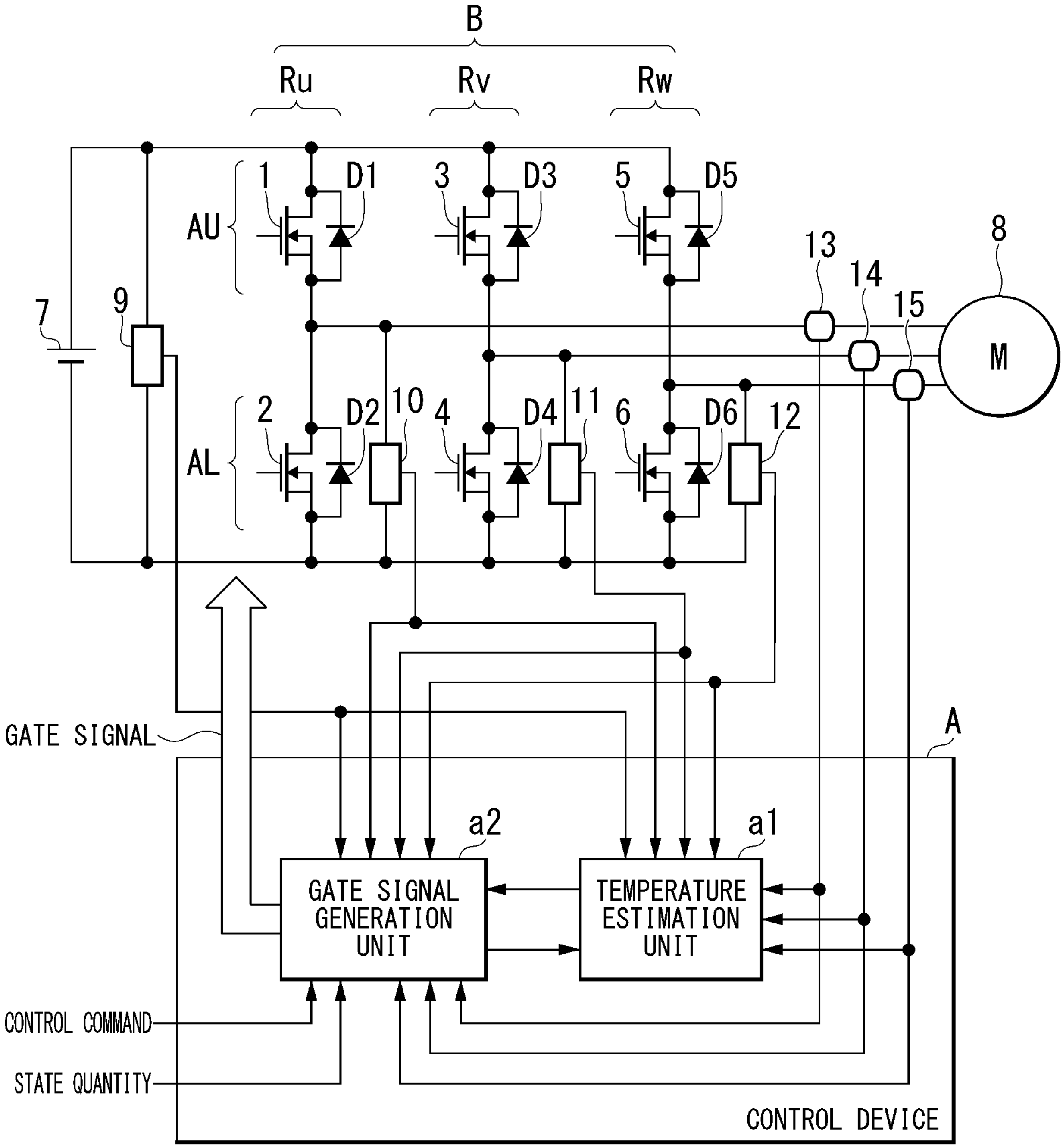
B
Ru
Rv
Rw
AU
AL
1
D1
3
D3
5
D5
2
D2
10
4
D4
11
6
D6
12
7
9
8
M
13
14
15
A
a2
a1
GATE SIGNAL
GATE SIGNAL GENERATION UNIT
TEMPERATURE ESTIMATION UNIT
CONTROL COMMAND
STATE QUANTITY
CONTROL DEVICE

FIG. 2

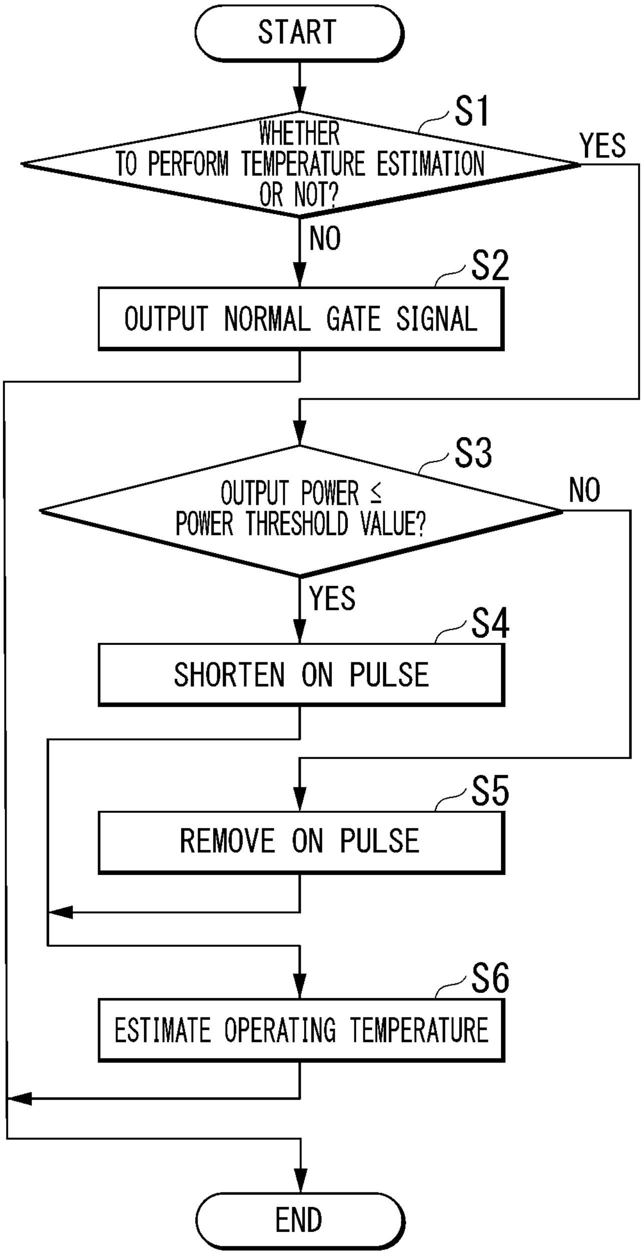
START
S1
WHETHER TO PERFORM TEMPERATURE ESTIMATION OR NOT?
YES
NO
S2
OUTPUT NORMAL GATE SIGNAL
S3
OUTPUT POWER ≤ POWER THRESHOLD VALUE?
NO
YES
S4
SHORTEN ON PULSE
S5
REMOVE ON PULSE
S6
ESTIMATE OPERATING TEMPERATURE
END

FIG. 3

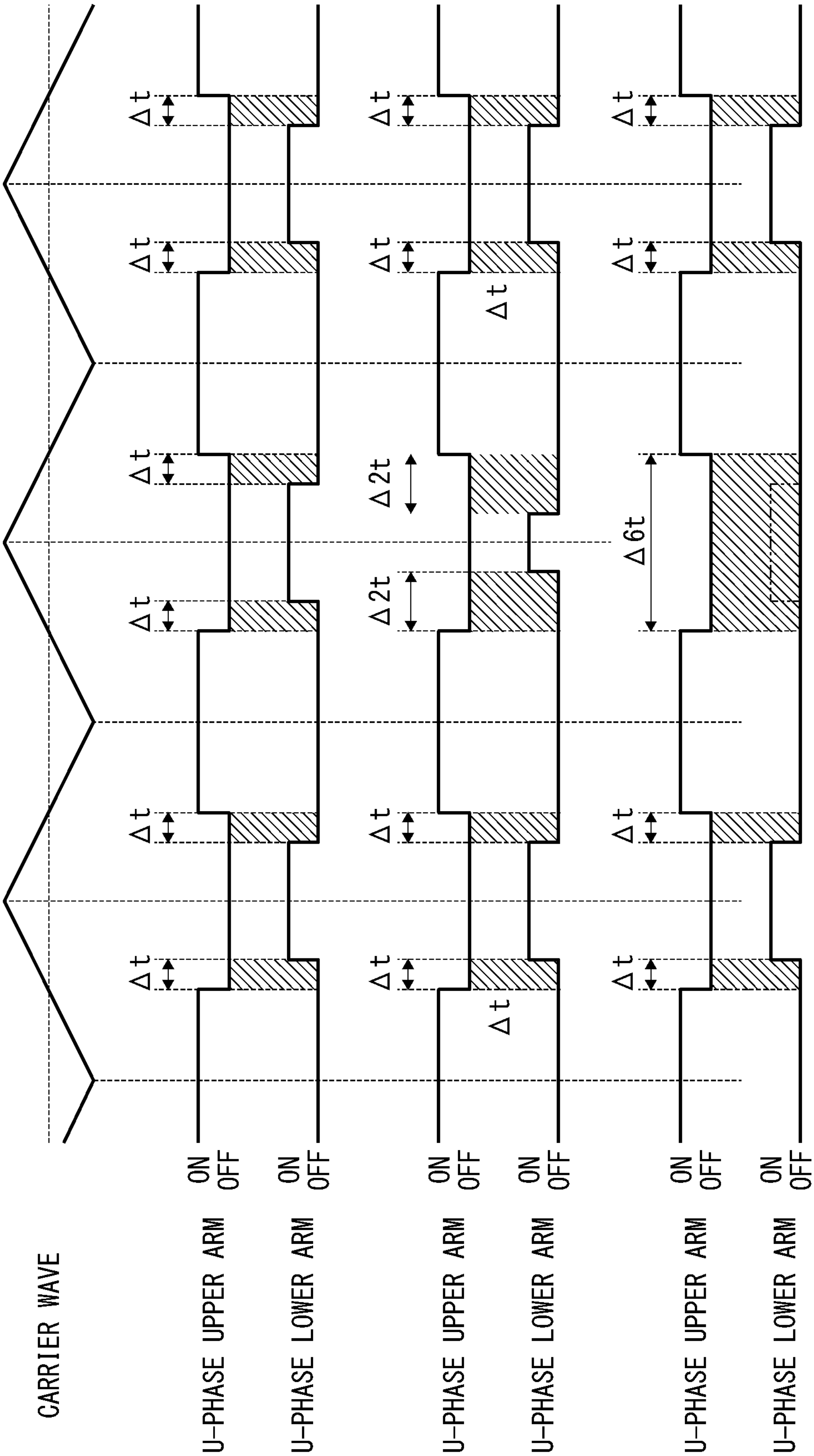
CARRIER WAVE
U-PHASE UPPER ARM
ON
OFF
U-PHASE LOWER ARM
ON
OFF
U-PHASE UPPER ARM
ON
OFF
U-PHASE LOWER ARM
ON
OFF
U-PHASE UPPER ARM
ON
OFF
U-PHASE LOWER ARM
ON
OFF
Δt
Δ2t
Δ6t

FIG. 4

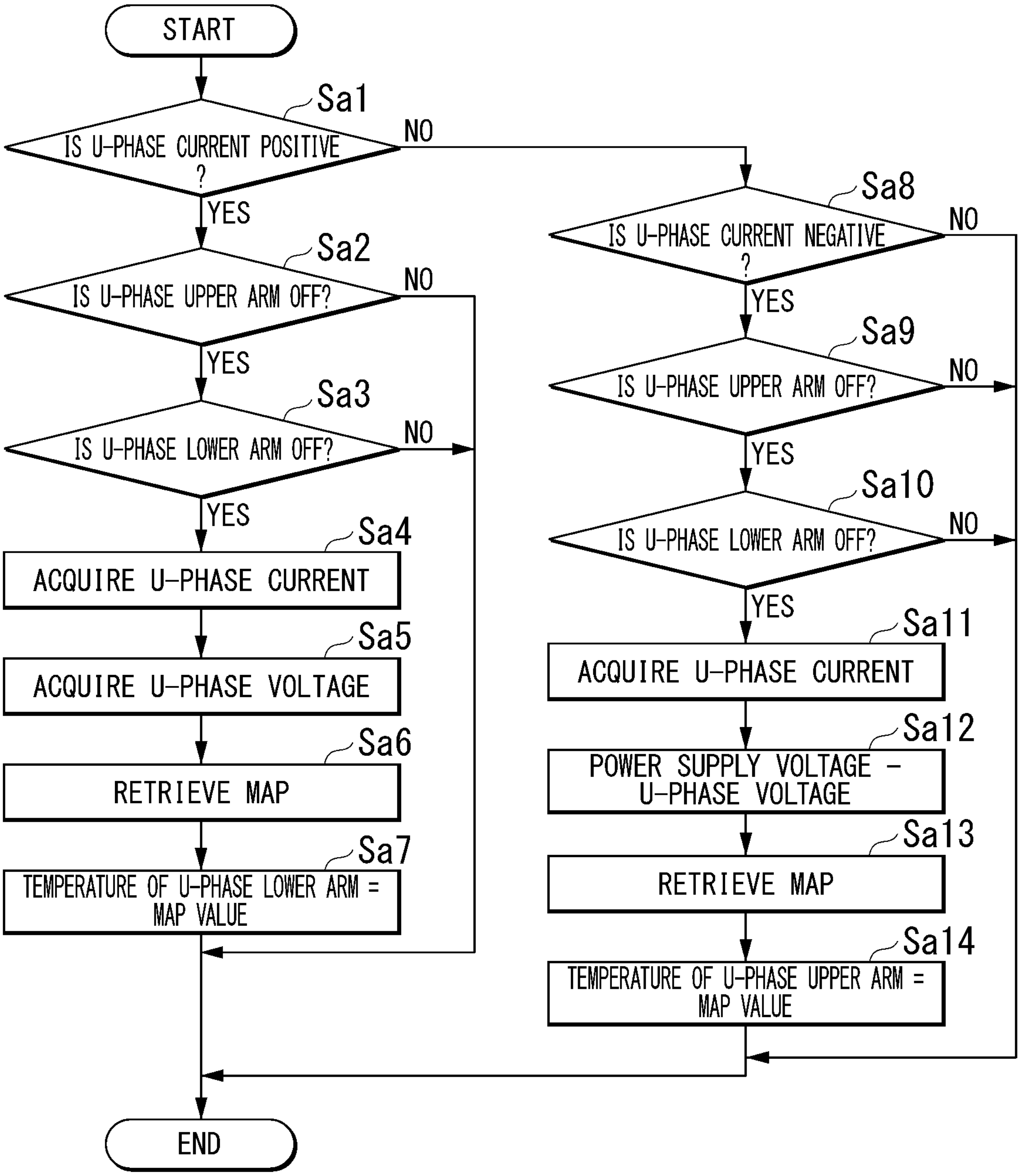
START
Sa1
IS U-PHASE CURRENT POSITIVE ?
NO
YES
Sa2
IS U-PHASE UPPER ARM OFF?
NO
YES
Sa3
IS U-PHASE LOWER ARM OFF?
NO
YES
Sa4
ACQUIRE U-PHASE CURRENT
Sa5
ACQUIRE U-PHASE VOLTAGE
Sa6
RETRIEVE MAP
Sa7
TEMPERATURE OF U-PHASE LOWER ARM = MAP VALUE
Sa8
IS U-PHASE CURRENT NEGATIVE ?
NO
YES
Sa9
IS U-PHASE UPPER ARM OFF?
NO
YES
Sa10
IS U-PHASE LOWER ARM OFF?
NO
YES
Sa11
ACQUIRE U-PHASE CURRENT
Sa12
POWER SUPPLY VOLTAGE − U-PHASE VOLTAGE
Sa13
RETRIEVE MAP
Sa14
TEMPERATURE OF U-PHASE UPPER ARM = MAP VALUE
END

FIG. 5

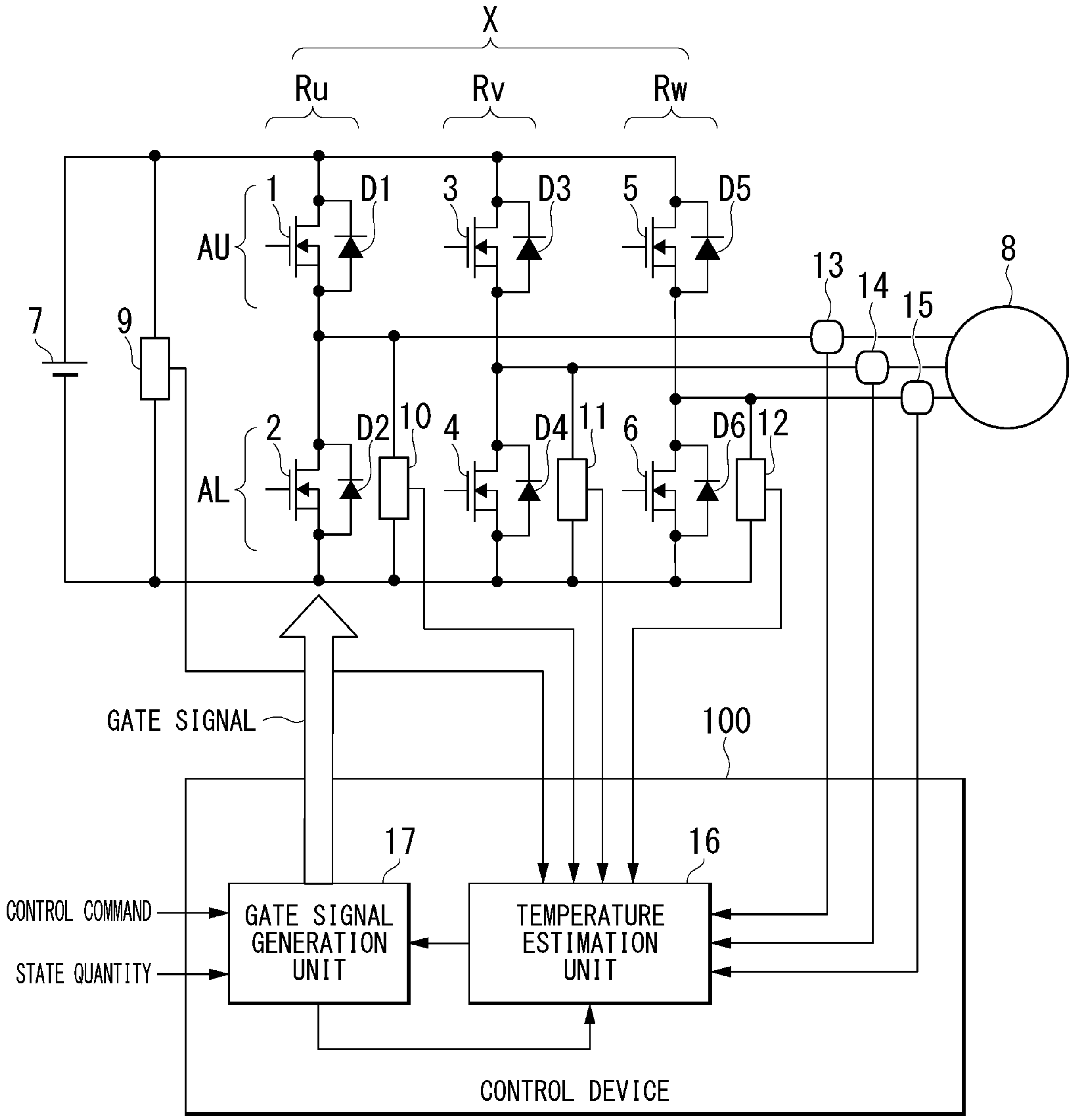
X
Ru
Rv
Rw
1
D1
3
D3
5
D5
AU
13
14
15
8
7
9
2
D2
10
4
D4
11
6
D6
12
AL
GATE SIGNAL
100
17
16
CONTROL COMMAND
STATE QUANTITY
GATE SIGNAL GENERATION UNIT
TEMPERATURE ESTIMATION UNIT
CONTROL DEVICE

FIG. 6

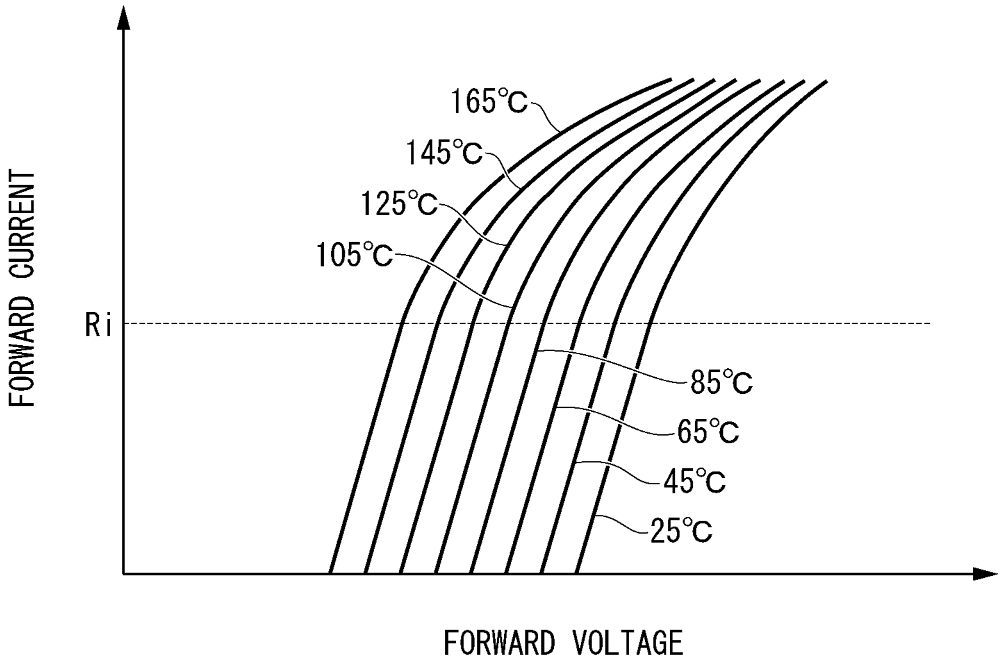
FORWARD CURRENT
Ri
165°C
145°C
125°C
105°C
85°C
65°C
45°C
25°C
FORWARD VOLTAGE

FIG. 7

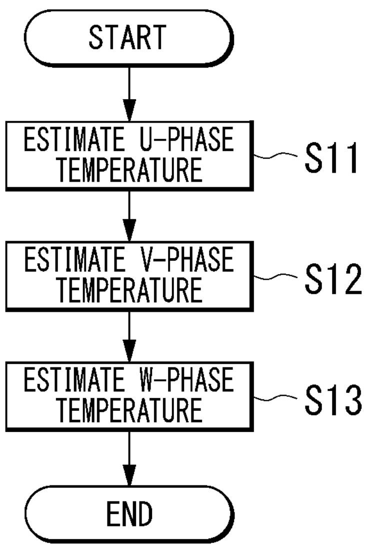
START
ESTIMATE U-PHASE TEMPERATURE
S11
ESTIMATE V-PHASE TEMPERATURE
S12
ESTIMATE W-PHASE TEMPERATURE
S13
END

FIG. 8

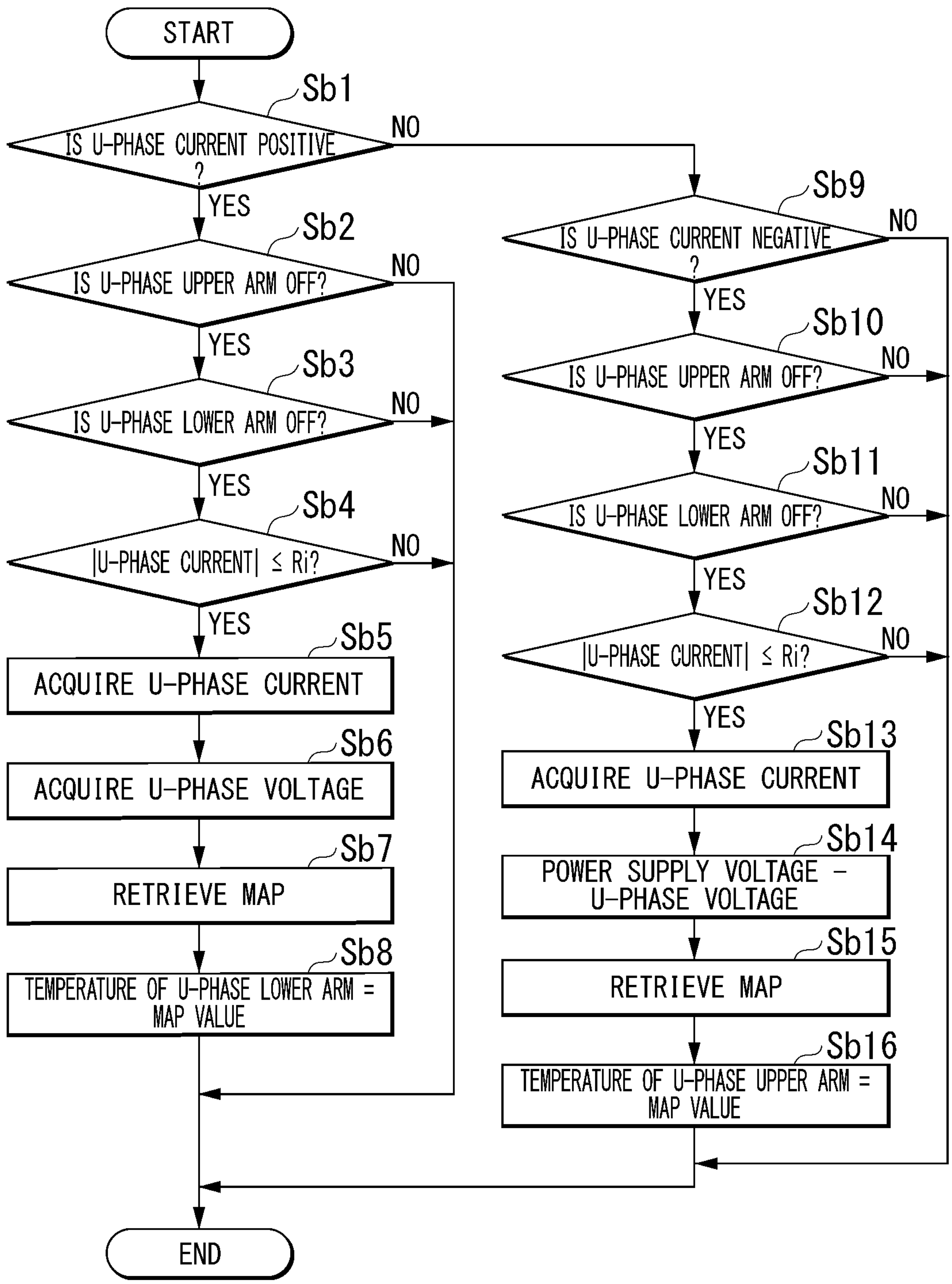
START
Sb1
IS U-PHASE CURRENT POSITIVE ?
NO
YES
Sb2
IS U-PHASE UPPER ARM OFF?
NO
YES
Sb3
IS U-PHASE LOWER ARM OFF?
NO
YES
Sb4
|U-PHASE CURRENT| ≤ Ri?
NO
YES
Sb5
ACQUIRE U-PHASE CURRENT
Sb6
ACQUIRE U-PHASE VOLTAGE
Sb7
RETRIEVE MAP
Sb8
TEMPERATURE OF U-PHASE LOWER ARM = MAP VALUE
Sb9
IS U-PHASE CURRENT NEGATIVE ?
NO
YES
Sb10
IS U-PHASE UPPER ARM OFF?
NO
YES
Sb11
IS U-PHASE LOWER ARM OFF?
NO
YES
Sb12
|U-PHASE CURRENT| ≤ Ri?
NO
YES
Sb13
ACQUIRE U-PHASE CURRENT
Sb14
POWER SUPPLY VOLTAGE - U-PHASE VOLTAGE
Sb15
RETRIEVE MAP
Sb16
TEMPERATURE OF U-PHASE UPPER ARM = MAP VALUE
END

FIG. 9

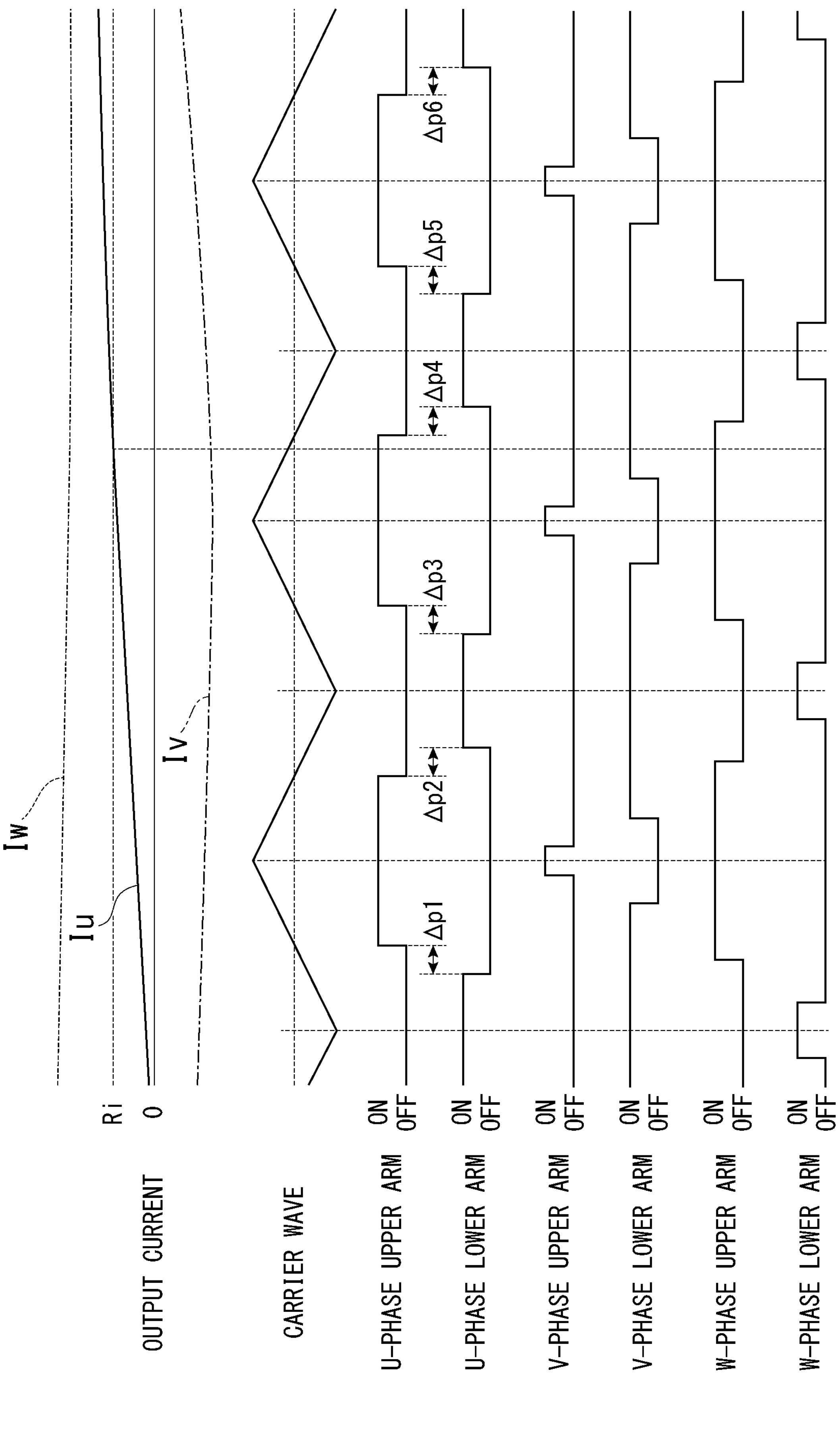
OUTPUT CURRENT
Ri
0
Iw
Iu
Iv
CARRIER WAVE
U-PHASE UPPER ARM
U-PHASE LOWER ARM
V-PHASE UPPER ARM
V-PHASE LOWER ARM
W-PHASE UPPER ARM
W-PHASE LOWER ARM
ON
OFF
Δp1
Δp2
Δp3
Δp4
Δp5
Δp6

FIG. 10

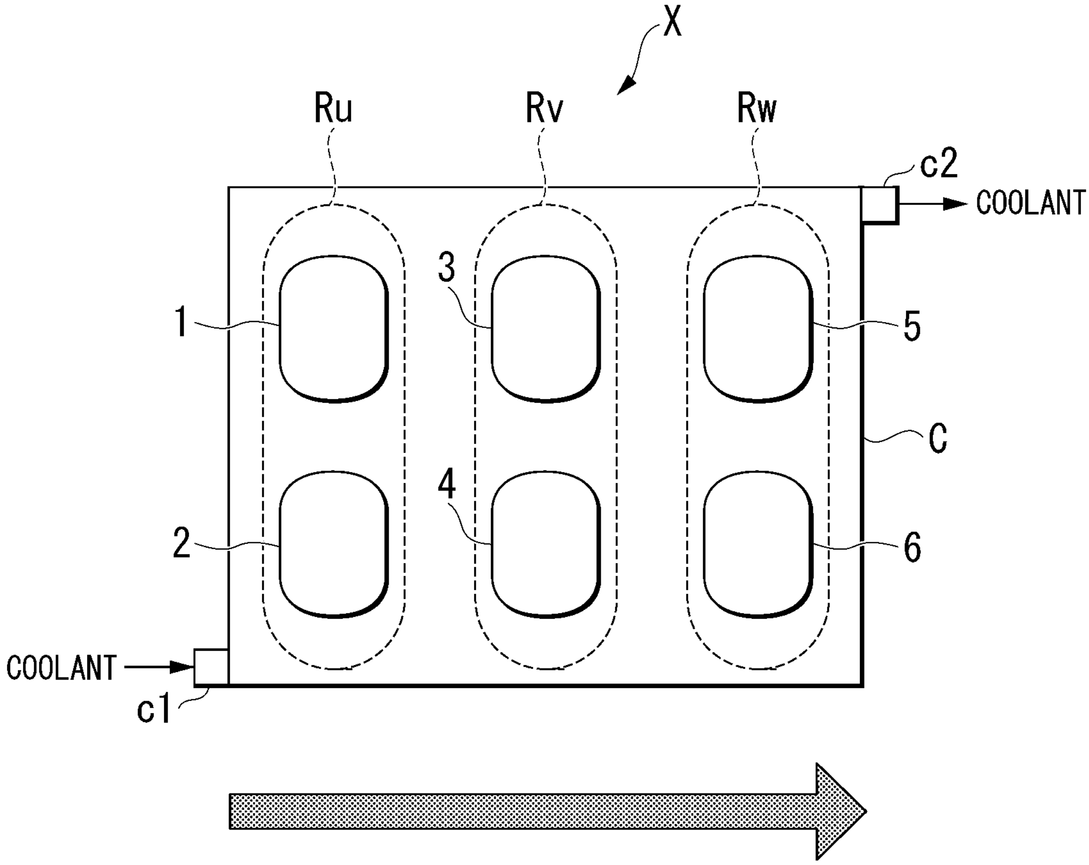

## INTERNATIONAL SEARCH REPORT

International application No.
**PCT/JP2021/040626**

**A. CLASSIFICATION OF SUBJECT MATTER**

***H02M 7/48***(2007.01)i
FI: H02M7/48 E; H02M7/48 M

According to International Patent Classification (IPC) or to both national classification and IPC

**B. FIELDS SEARCHED**

Minimum documentation searched (classification system followed by classification symbols)

H02M 7/42-7/98

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2019-13102 A (RENESAS ELECTRONICS CORP) 24 January 2019 (2019-01-24) paragraphs [0080]-[0151], fig. 9, 12 | 1-7 |
| Y | JP 2005-168262 A (NISSAN MOTOR CO LTD) 23 June 2005 (2005-06-23) paragraphs [0008], [0009], [0018], [0023]-[0027], [0039], [0048], fig. 1-3 | 1-7 |
| Y | JP 2020-10600 A (DENSO CORP) 16 January 2020 (2020-01-16) paragraphs [0044], [0045], fig. 8 | 6 |
| A | entire text, all drawings | 1-5, 7 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 December 2021** | **28 December 2021** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2021/040626**

| Patent document cited in search report | Publication date (day/month/year) | Patent family member(s) | Publication date (day/month/year) |
|---|---|---|---|
| JP 2019-13102 A | 24 January 2019 | US 2019/0007039 A1 paragraphs [0104]-[0181], fig. 9, 12 | |
| JP 2005-168262 A | 23 June 2005 | (Family: none) | |
| JP 2020-10600 A | 16 January 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020186355 A
- JP 2020201669 A
- JP 2019216571 A